# EUROPEAN PATENT APPLICATION

(11) **EP 3 848 219 A1**
(43) Date of publication of application: **14.07.2021**
(21) Application number: 20170234.7
(22) Date of filing: 17.04.2020
(51) Int. Cl.: B60K 35/00, B60R 11/02, G06F 1/16, G09F 9/30, G09F 9/37

(54) **DISPLAY DEVICE FOR VEHICLE**

(30) Priority: 09.01.2020 KR 20200003295
(71) Applicant: LG Electronics Inc., Seoul 07336 (KR)
(72) Inventor: KANG, Seung Mo, 06668 Seoul (KR); SON, Sang-Hyeun, 22625 Incheon (KR); DIBOINE, Romain, 06621 Seoul (KR)
(74) Representative: Schornack, Oliver

(57) **Abstract**

A display device for a vehicle according to an embodiment may include a first frame secured to a dashboard of a vehicle, a second frame configured to be movable in a first direction with respect to the first frame, a flexible display configured such that the externally exposed area thereof changes according to movement of the second frame in the first direction, and an input interface configured to receive input for control of operation of the flexible display.

## Description

### CROSS-REFERENCE TO RELATED APPLICATION

This application claims the benefit of an earlier filing date of and the right of priority to Korean Application No. 10-2020-0003295, filed in Korea on January 9, 2020, the contents of which are incorporated by reference herein in their entirety.

### BACKGROUND

### 1. Technical Field

The present disclosure relates to a display device for a vehicle, and more particularly to a display device for a vehicle to which a flexible display is applied.

### 2. Description of Related Art

The description in this section merely provides background information on embodiments of the present disclosure and does not necessarily constitute the related art.

With the development of flexible displays that are bendable while displaying image information, foldable-type devices to which a flexible display is applied are being researched and .

In such devices, since a flexible display has a folding structure, it is possible to conveniently change the size of a screen on which image information is displayed, thereby saving space for use, enhancing portability, and realizing a large-screen display.

As another type of device using a flexible display, a rollable or bendable device including a rollable display is being researched and developed. In such devices, the flexible display can be wound to reduce a size or an area of the entire display, and the flexible display can be unwound to increase the size or the area of the entire.

A vehicle is equipped at a dashboard thereof with a display device for displaying information related to driving of the vehicle and devices included in the vehicle, in order to provide convenience to a user such as a driver, and to aid safe driving.

Implementing such a display device for a vehicle as a flexible display enables space to be saved for use in a dashboard of a vehicle, which has a relatively small volume, and realization of a large-screen display, thereby improving user. Accordingly, there is a need for studies regarding such display devices.

### SUMMARY OF THE INVENTION

An aspect of the present disclosure is to provide a display device for a vehicle to which a flexible display is applied.

Another aspect of the present disclosure is to provide a display device for a vehicle that enables convenient adjustment of the size of a screen of a flexible display.

Aspects of the present disclosure are not limited to the aspects described above, and other aspects that are not stated herein will be clearly understood by those skilled in the art from the following description.

A display device for a vehicle according to an embodiment of the present disclosure may include a first frame secured to the dashboard of the vehicle, a second frame configured to be movable in a first direction with respect to the first frame, a flexible display configured such that the externally exposed area thereof changes according to movement of the second frame in the first direction, and an input interface configured to receive input for control of operation of the flexible display.

The externally exposed area of the flexible display may change based on the characteristics of each user or each device provided in the vehicle.

The input interface may be implemented as a hard key input interface disposed at a predetermined portion in the vehicle.

The input interface may be implemented as a soft key input interface displayed on the flexible display.

The flexible display may be configured such that the externally exposed area thereof changes based on a control value inputted by a user through the input interface.

The flexible display may reproduce a screen for control of a device provided in the vehicle, and the externally exposed area of the flexible display may change according to the characteristics of each device.

The flexible display may reproduce at least one of a navigation screen, a screen for operation of an air-conditioner, a screen for control of a driving device, a screen for video playback, or a screen for manipulation of an audio device, and the externally exposed area of the flexible display may be configured to be largest when the navigation screen is reproduced.

The display device according to an embodiment of the present disclosure may further include a camera disposed so as to be oriented toward a user in the driver seat. A controller provided in the vehicle may identify a user in the driver seat by recognizing the face of the user using the camera, and may control the size of the externally exposed area of the flexible display based on a preset value corresponding to the identified user.

Upon receiving a control signal inputted through the input interface, the controller may control the size of the externally exposed area of the flexible display based on the control signal inputted through the input interface, rather than based on a preset value corresponding to a user identified through the camera.

The display device according to an embodiment may further include a roller rotatably coupled to the second frame and configured to move in the first direction according to movement of the second frame. The flexible display may be partially wound around the roller and may be bent by the roller. One end portion of the flexible display may be secured to the first frame. The externally exposed area of the front surface of the flexible display may increase in response to the distance between the first frame and the roller increasing.

The display device according to an embodiment may further include a moving part configured to move the roller in the first direction, and an actuator configured to provide driving force to the moving part.

The moving part may include a moving plate to which the second frame is coupled, the moving plate being configured to move in the first direction according to movement of the roller in the first direction, and a chain coupled at one side thereof to the first frame and configured to be bent by the roller and to support at least a portion of the rear surface of the flexible display.

The moving part may further include a backplate disposed so as to face the flexible display. At least a portion of the backplate may be formed as an elastic metal plate, and the backplate may include a through-hole formed in a portion thereof corresponding to the roller.

The actuator may include a first bracket coupled to the first frame, a second bracket coupled to the first bracket and disposed such that a longitudinal direction thereof is oriented in the first direction, and a third bracket coupled to the moving plate and configured to move in the first direction with respect to the second bracket.

The second bracket may include a plurality of coils arranged at predetermined intervals in the first direction and configured to receive power, and the third bracket may include a plurality of magnets disposed opposite the coils and arranged at predetermined intervals in the first direction.

A display device for a vehicle according to another embodiment may further include a first roller disposed so as to be spaced apart from the first frame, and a second roller rotatably coupled to the second frame and configured to move in the first direction according to movement of the second frame. The flexible display may be partially wound around the second roller and may be bent by the second roller. The externally exposed area of the front surface of the flexible display may increase in response to the distance between the first roller and the second roller increasing.

The display device according to another embodiment may further include a moving part configured to move the second roller in the first direction, and a guide part configured to guide movement of the moving part.

The moving part may include a moving plate coupled at one end portion to the second frame and configured to move in the first direction according to movement of the second roller in the first direction, and a chain coupled at one end portion thereof to the moving plate and configured to be bent by the first roller and to support at least a portion of the rear surface of the flexible display.

The display device according to another embodiment may further include a third roller rotatably coupled to the second frame and configured to support the flexible display such that a portion of the flexible display is in close contact with the moving plate.

The guide part may include a connector coupled to one end of the flexible display, a first control bar coupled at one end thereof to the connector and configured to be movable in a direction perpendicular to the first direction with respect to the connector and to rotate according to movement of the second roller in the first direction, a second control bar coupled at one end thereof to the opposite end of the first control bar and configured to rotate according to movement of the second roller in the first direction, and an inner plate secured to the first frame and configured to allow a coupling portion between the first control bar and the second control bar to pass therethrough.

The connector may include a first slot into which a first protrusion protruding from one end of the first control bar is inserted, the first slot being formed such that a longitudinal direction thereof is oriented in a direction perpendicular to the first direction and being configured to guide movement of the first control bar with respect to the connector. The inner plate may include a second slot into which the coupling portion between the first control bar and the second control bar is inserted, the second slot being configured to guide movement of the coupling portion. The chain may include a third slot into which a second protrusion protruding from one end of the second control bar is inserted, the third slot being formed such that a longitudinal direction thereof is oriented in a direction perpendicular to the first direction and being configured to guide movement of the second control bar with respect to the chain.

As is apparent from the above description, according to embodiments, upon receiving user input, a controller may perform control such that a flexible display has an externally exposed area corresponding to the user input, thereby providing user convenience.

According to embodiments, the size of the externally exposed area of the flexible display may be appropriately controlled according to the type of screen displayed, thereby providing user convenience.

According to embodiments, the flexible display may be controlled such that the size of the externally exposed area thereof varies differently according to each user, thereby providing user convenience.

### BRIEF DESCRIPTION OF THE DRAWINGS

The above and other aspects, features, and advantages of the present disclosure will become apparent from the detailed description of the following aspects in conjunction with the accompanying drawings, in which:
FIG. 1 is a block diagram for explaining a vehicle display device according to an embodiment;
FIG. 2 is a perspective view showing the vehicle display device according to an embodiment;
FIG. 3 is a perspective view showing the vehicle display device, the state of which has changed from the state shown in FIG. 2;
FIG. 4 is a block diagram for explaining the operation of the vehicle display device according to an embodiment;
FIG. 5 is a perspective view showing the vehicle display device according to an embodiment;
FIG. 6 is a perspective view showing the vehicle display device, the state of which has changed from the state shown in FIG. 5;
FIG. 7 is a front view showing the vehicle display device according to an embodiment;
FIG. 8 is a side view of FIG. 7;
FIG. 9 is a view of a portion BB in FIG. 7 when viewed from the direction indicated in FIG. 7;
FIG. 10 is a front view showing the vehicle display device, the state of which has changed from the state shown in FIG. 7;
FIG. 11 is a side view of FIG. 10;
FIG. 12 is a perspective view showing some of the components of the vehicle display device according to an embodiment;
FIG. 13 is a perspective view showing the vehicle display device, the state of which has changed from the state shown in FIG. 12;
FIG. 14 is a view for explaining an actuator according to an embodiment;
FIG. 15 is a front view showing a vehicle display device according to another embodiment;
FIG. 16 is a view of a portion CC in FIG. 15 when viewed from the direction indicated in FIG. 15;
FIG. 17 is a perspective view showing a chain according to an embodiment;
FIG. 18 is a view for explaining the operation of the chain according to an embodiment;
FIG. 19 is a view showing a backplate according to an embodiment;
FIG. 20 is a perspective view showing the vehicle display device according to an embodiment;
FIG. 21 is a perspective view showing the vehicle display device, the state of which has changed from the state shown in FIG. 20;
FIG. 22 is a front view showing the vehicle display device according to an embodiment;
FIG. 23 is a cross-sectional view of a portion AA in FIG. 22 when viewed from the direction indicated in FIG. 22;
FIG. 24 is a view of a portion BB in FIG. 22 when viewed from the direction indicated in FIG. 22;
FIG. 25 is a front view showing the vehicle display device, the state of which has changed from the state shown in FIG. 22;
FIG. 26 is a cross-sectional view of a portion AA in FIG. 25 when viewed from the direction indicated in FIG. 25;
FIG. 27 is a perspective view showing some of the components of the vehicle display device according to an embodiment;
FIG. 28 is a perspective view showing the vehicle display device, the state of which has changed from the state shown in FIG. 27;
FIG. 29 is a front view showing a vehicle display device according to another embodiment;
FIG. 30 is a side view of FIG. 29;
FIG. 31 is a view of a portion CC in FIG. 29 when viewed from the direction indicated in FIG. 29;
FIG. 32 is a perspective view showing a chain according to an embodiment;
FIG. 33 is a view for explaining the operation of the chain according to an embodiment;
FIG. 34 is a view for explaining the operation of a first elastic part according to an embodiment;
FIG. 35 is a perspective view showing the first elastic part according to an embodiment;
FIG. 36 is a view for explaining the operation of a second elastic part according to an embodiment; and
FIG. 37 is a view showing a backplate according to an embodiment.

### DETAILED DESCRIPTION

Hereinbelow, embodiments will be described in greater detail with reference to the accompanying drawings. The embodiments may be modified in various ways and may have various forms, and specific embodiments will be illustrated in the drawings and will be described in detail herein. However, this is not intended to limit the embodiments to the specific embodiments, and the embodiment should be understood as including all modifications, equivalents, and replacements that fall within the spirit and technical scope of the embodiments.

Terms such as "first," "second," and other numerical terms when used herein do not imply a sequence or order unless clearly indicated by the context. These terms are only used to distinguish one element from another. In addition, terms, which are specially defined in consideration of the configurations and operations of the embodiments, are given only to explain the embodiments, and do not limit the scope of the embodiments.

In the description of the embodiment, in the case in which it is described as being formed on "on" or "under" of each element, "on" or "under" includes two elements directly contacting each other or one or more other elements being indirectly formed between the two elements. In addition, when expressed as "on" or "under", it may include not only upwards but also downwards with respect to one element.

In addition, relational terms to be described below such as "on/over/up" and "beneath/under/down" may be used to discriminate any one subject or element from another subject or element without necessarily requiring or comprehending a physical or logical relationship or sequence of subjects or elements.

Further, in the drawings, a rectangular coordinate system (x, y, z) may be used. In the drawings, the x-axis direction refers to a first direction.

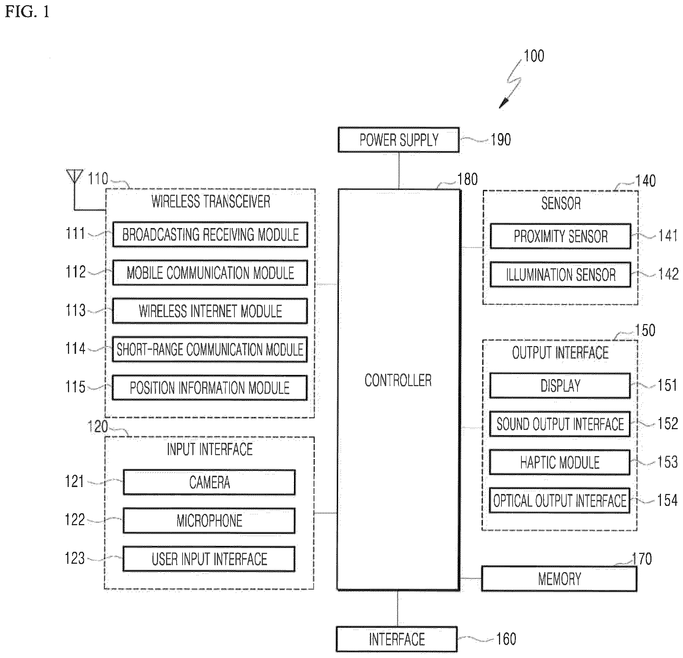

FIG. 1 is a block diagram for explaining a vehicle display device 100 according to an embodiment.

The vehicle display device 100 according to the embodiment may, for be mounted to, for example, a dashboard 10 of the vehicle, and may display information necessary for control of various devices used to drive the vehicle such as information necessary for driving of the vehicle, and information necessary to provide convenience to an occupant of the vehicle.

The vehicle display device 100 includes a wireless transceiver 110, an input interface 120, a sensor 140, an output interface 150, an interface 160, a memory 170, a controller 180, and a power supply 190. The components shown in FIG. 1 are not essential to implement the vehicle display device, and the vehicle display device described in this specification may include a greater or smaller number of components than those described above.

More specifically, among the components described above, the wireless transceiver 110 may include one or more modules that enable wireless communication between the vehicle display device 100 and a wireless communication system, between the vehicle display device 100 and another vehicle display device 100, or between the vehicle display device 100 and an external server. Further, the wireless transceiver 110 may include one or more modules which connect the vehicle display device 100 to one or more networks.

The wireless transceiver 110 may include at least one of a broadcasting receiving module 111, a mobile communication module 112, a wireless Internet module 113, a short-range communication module 114, or a position information module 115.

The input interface 120 may include a camera 121 or an image input interface which receives input of an image signal, a microphone 122 or an audio input interface which receives input of an audio signal, and a user input interface 123 (for example, a touch key or a mechanical key) which receives information from a user. Voice data or image data collected by the input interface 120 is analyzed and processed as a control command of the user.

The sensor 140 may include one or more sensors that sense at least one of information in the vehicle display device, surrounding environment information around the vehicle display device, or user information. For example, the sensor 140 may include at least one of a proximity sensor 141, an illumination sensor 142, a touch sensor, an acceleration sensor, a magnetic sensor, a G-sensor, a gyroscope sensor, a motion sensor, an RGB sensor, an infrared (IR) sensor, a finger scan sensor, an ultrasonic sensor, an optical sensor (for example, a camera 121 or a microphone 122), a battery gauge, an environment sensor (for example, a barometer, a hygrometer, a thermometer, a radiation sensor, a thermal sensor, and a gas sensor), or a chemical sensor (for example, an electronic nose, a healthcare sensor, and a biometric sensor). Further, the vehicle display device disclosed in the present specification may combine and utilize information sensed by at least two sensors from the above-mentioned sensors.

The output interface 150 is intended to generate an output related to a visual, aural, or tactile stimulus, and may include at least one among a display 151, sound output interface 152, haptic module 153, and optical output interface 154. The display 151 may be configured as a touch screen by forming a mutual layered structure with a touch sensor or being formed integrally therewith. The touch screen may serve as a user input interface 123 that provides an input interface between the vehicle display device 100 and the user, and at the same time, may provide an output interface between the vehicle display device 100 and the user.

The interface 160 serves as a passage between the vehicle display device 100 and various types of external devices connected to the vehicle display device 100. The interface 160 may include at least one of a wired/wireless headset port, an external charger port, a wired/wireless data port, a memory card port, a port which connects a device equipped with an identification module, an audio input/output (I/O) port, a video input/output (I/O) port, or an earphone port. The vehicle display device 100 may perform appropriate control related to the connected external device in accordance with the connection of the external device to the I/O connector 160.

Further, the memory 170 stores data for supporting various functions of the vehicle display device 100. The memory 170 may store a plurality of application programs or applications that are driven by the vehicle display device 100, data for operating the vehicle display device 100, and instructions. At least some of the application programs may be downloaded via an external server through wireless communication. Further, at least some of the application programs may be present in the vehicle display device 100 from the time of release in order to perform the basic functions (for example, incoming-call, outgoing-call, message reception, and message-sending functions) of the vehicle display device 100. The application programs may be stored in the memory 170, and may be installed in the vehicle display device 100 so as to be driven by the controller 180 to perform an operation (or functions) of the vehicle display device.

In addition to the operation related to the application programs, the controller 180 generally controls the overall operation of the vehicle display device 100. The controller 180 may process signals, data, or information which is inputted or outputted through the above-described components, or drive the application programs stored in the memory 170 to provide or process appropriate information or functions to the user.

Further, in order to drive the application program stored in the memory 170, the controller 180 may control at least some of components described with reference to FIG. 1. Moreover, the controller 180 may combine and operate at least two of the components included in the vehicle display device 100 to drive the application program.

The power supply 190 receives external power and supplies power to the respective components included in the vehicle display device 100 under the control of the controller 180. At least some of the above-described components may operate in cooperation with each other to implement the operation, the control, or the control method of the vehicle display device according to various embodiments, which will be described below. Further, the operation, the control, or the control method of the vehicle display device may be implemented in the vehicle display device by driving at least one application program stored in the memory 170.

Hereinafter, prior to describing various embodiments implemented by the vehicle display device 100 described above, the above-mentioned components will be described in more detail with reference to FIG. 1.

First, the wireless transceiver 110 will be described. The broadcasting receiving module 111 of the wireless transceiver 110 receives a broadcasting signal and/or broadcasting-related information from an external broadcasting management server through a broadcasting channel. The broadcasting channel may include a satellite channel and a ground wave channel. Two or more broadcasting receiving modules for simultaneous broadcasting reception or broadcasting channel switching for at least two broadcasting channels may be provided in the vehicle display device 100.

The broadcasting management server may refer to a server which generates and transmits a broadcasting signal and/or broadcasting-related information, or a server which is supplied with a previously generated broadcasting signal and/or broadcasting-related information and transmits the broadcasting signal and/or the broadcasting-related information to the vehicle display device. The broadcasting signal includes not only a TV broadcasting signal, a radio broadcasting signal, and a data broadcasting signal, but also a broadcasting signal obtained by combining a TV broadcasting signal or a radio broadcasting signal with a data broadcasting signal.

The broadcasting signal may be encoded according to at least one technical standard for transmitting and receiving a digital broadcasting signal (or broadcasting schemes, for example, ISO, IEC, DVB, or ATSC), and the broadcasting receiving module 111 may receive the digital broadcasting signal using an appropriate method for the technical specification determined by the technical standard.

The broadcasting-related information may refer to information related to a broadcasting channel, a broadcasting program, or a broadcasting service provider. The broadcasting-related information may also be provided through the mobile communication network. In this case, the broadcasting-related information may be received by the mobile communication module 112.

The broadcasting-related information may exist in various types such as an electronic program guide of digital multimedia broadcasting (DMB) or an electronic service guide of a digital video broadcast-handheld (DVB-H). The broadcasting signal and/or the broadcasting-related information received by the broadcasting receiving module 111 may be stored in the memory 170.

The modem 112 may transmit/receive a wireless signal to/from at least one among a base station, an external terminal, or a server on a mobile communication network established according to the technical standards or communication methods for mobile communication (for example, Global System for Mobile communication (GSM), Code Division Multi Access (CDMA), Code Division Multi Access 2000 (CDMA2000), Enhanced Voice-Data Optimized or Enhanced Voice-Data Only (EV-DO), Wideband CDMA (WCDMA), High Speed Downlink Packet Access (HSDPA), High Speed Uplink Packet Access (HSUPA), Long Term Evolution (LTE), and Long Term Evolution-Advanced (LTE-A)).

The wireless signal may include a voice call signal, a video call signal, or various types of data in accordance with transmission or reception of a text/multimedia message.

The wireless Internet module 113 refers to a module for wireless Internet access and may be built in or external to the vehicle display device 100. The wireless Internet module 113 may be configured to transmit/receive a wireless signal in a communication network according to wireless Internet technologies.

Wireless Internet technologies may include wireless LAN (WLAN), wireless fidelity (Wi-Fi), Wi-Fi direct, Digital Living Network Alliance (DLNA), wireless broadband (WiBro), Worldwide Interoperability for Microwave Access (WiMAX), High Speed Downlink Packet Access (HSDPA), High Speed Uplink Packet Access (HSUPA), Long Term Evolution (LTE), and Long Term Evolution-Advanced (LTE-A). The wireless Internet module 113 may transmit or receive data in accordance with at least one wireless Internet technology, including Internet technologies which have not been described above.

From the viewpoint that the wireless Internet connection by WiBro, HSDPA, HSUPA, GSM, CDMA, WCDMA, LTE, LTE-A, etc. is performed through a mobile communication network, the wireless Internet module 113 which performs the wireless Internet connection through the mobile communication network may be understood as a type of the mobile communication module 112.

The short-range communication module 114 may support short-range communication using at least one of Bluetooth™, infrared data association (IrDA), ultra wideband (UWB), ZigBee, Short-range Communication (NFC), wireless fidelity (Wi-Fi), Wi-Fi Direct, or Wireless Universal Serial Bus (Wireless USB). The short-range communication module 114 may support wireless communication between the vehicle display device 100 and the wireless communication system, between the vehicle display device 100 and another vehicle display device 100, or between the vehicle display device 100 and a network in which another vehicle display device 100 (or an external server) is located through the short-range wireless communication network. The short-range wireless communication network may be a short-range wireless personal communication network.

The GNSS sensor 115 is a module for obtaining the location (or the current location) of a vehicle display device, and its representative examples include a global positioning system (GPS) module or a Wi-Fi module. For example, when the GPS module is utilized, the vehicle display device may obtain the position of the vehicle display device using a signal transmitted from a GPS satellite. As another example, when the Wi-Fi module is utilized, the vehicle display device may obtain the position of the vehicle display device based on information of a wireless access point (AP) that transmits and receives wireless signals to and from the Wi-Fi module. If necessary, the position information module 115 may perform a function of another module of the wireless transceiver 110 to substitutably or additionally obtain data on the position of the vehicle display device. The position information module 115 is a module used to obtain the position (or the current position) of the vehicle display device, and is not limited to a module that directly calculates or obtains the position of the vehicle display device.

Next, the input interface 120 is provided to input video information (or signals), audio information (or signals), data, or information inputted from the user. In order to receive input of video information, the vehicle display device 100 may include one or more cameras 121. The camera 121 processes an image frame such as a still image or a moving image obtained by an image sensor in a video call mode or a photographing mode. The processed image frames may be displayed on the display 151 or stored in the memory 170. Further, the plurality of cameras 121 equipped in the vehicle display device 100 may be disposed to form a matrix structure, and a plurality of pieces of image information having various angles or focal points may be inputted to the vehicle display device 100 through the cameras 121 that form the matrix structure. Further, the cameras 121 may be disposed to have a stereo structure to obtain a left image and a right image to implement a stereoscopic image.

The microphone 122 processes an external sound signal as electronic voice data. The processed voice data may be utilized in various forms in accordance with a function being performed by the vehicle display device 100 (or an application program which is being executed). In the meantime, in the microphone 122, various noise removal algorithms which remove noise generated during the process of receiving the external sound signal may be implemented.

The user input interface 123 receives information from the user, and when the information is inputted through the user input interface 123, the controller 180 may control the operation of the vehicle display device 100 so as to correspond to the inputted information. The user input interface 123 may include a mechanical input interface (or a mechanical key, for example, a button located on a front, rear, or side surface of the vehicle display device 100, a dome switch, a jog wheel, a jog switch, or the like) and a touch type input interface. As one example, the touch type input interface may include a virtual key, a soft key, or a visual key displayed on the touch screen via a software process, or may include a touch key disposed on a portion other than the touch screen. The virtual key or the visual key may be displayed on the touch screen in various shapes, and for example, may be formed by graphics, text, icons, video, or a combination thereof.

The sensor 140 senses at least one of information in the vehicle display device, surrounding environment information around the vehicle display device, or user information, and generates a sensing signal corresponding to the sensed information. The controller 180 may control the driving or the operation of the vehicle display device 100, or may perform data processing, functions, or operations related to the application program installed in the vehicle display device 100, based on the sensing signal. Representative sensors among the various sensors which may be included in the sensor 140 will be described in more detail below.

First, the proximity sensor 141 is a sensor which senses the presence of an object approaching a predetermined sensing surface or nearby objects, using an electromagnetic field force or infrared ray without any mechanical contact. The proximity sensor 141 may be disposed in an internal area of the vehicle display device, which is enclosed by the above-described touch screen, or in the vicinity of the touch screen.

Examples of the proximity sensor 141 may include a transmission type photoelectric sensor, a direct reflection type photoelectric sensor, a mirror reflection type photoelectric sensor, a high frequency oscillation type proximity sensor, a capacitive proximity sensor, a magnetic proximity sensor, and an infrared proximity sensor. When the touch screen is a capacitive type, the proximity sensor 141 may be configured to detect the proximity of the object with a change in the electric field in accordance with the proximity of the object having conductivity. In this case, the touch screen (or the touch sensor) itself may be classified as a proximity sensor.

For convenience of description, when an object approaches the touch screen without contacting the touch screen, and it is recognized that the object is located above the touch screen, it is referred to as a "proximity touch". When the object actually touches the touch screen, it is referred to as a "contact touch". A position at which the object proximately touches the touch screen refers to a position at which the object vertically corresponds to the touch screen when the object proximately touches the touch screen. The proximity sensor 141 may sense a proximate touch and a proximate touch pattern (for example, a proximate touch distance, a proximate touch direction, a proximate touch speed, a proximate touch time, a proximate touch position, a proximate touch movement state, etc.). As described above, the controller 180 may process data (or information) corresponding to the proximate touch operation and the proximate touch pattern sensed by the proximity sensor 141, and may further output visual information corresponding to the processed data on the touch screen. Furthermore, the controller 180 may control the vehicle display device 100 to process different operations or data (or information) depending on whether the touch on the same point on the touch screen is a proximity touch or a contact touch.

The touch sensor senses a touch (or a touch input) applied to the touch screen (or the display 151) using at least one of various touch types such as a resistive film type, a capacitive type, an infrared type, an ultrasonic type, and a magnetic field type.

For example, the touch sensor may be configured to convert a change of a pressure which is applied to a specific portion of the touch screen, or a capacitance which is generated in a specific portion, into an electrical input signal. The touch sensor may be configured to detect a position and an area where a touch subject which applies a touch onto the touch screen is touched on the touch sensor, and a capacitance at the time of the touch. Here, the touch subject is an object which applies a touch to the touch sensor, and may include, for example, a finger, a touch pen, a stylus pen, and a pointer.

As described above, when there is a touch input to the touch sensor, corresponding signals are transmitted to a touch controller. The touch controller processes the signal(s) and then transmits corresponding data to the controller 180. By doing this, the controller 180 may confirm which area of the display 151 is touched. Here, the touch controller may be a separate component from the controller 180, or may be the controller 180 itself.

The controller 180 may perform different control or the same control depending on a type of a touch subject which touches the touch screen (or a touch key equipped other than the touch screen). Whether to perform the different control or the same control depending on the type of touch subject may be determined in accordance with an operating state of the current vehicle display device 100 or an application program which is being executed.

The touch sensor and proximity sensor described above may, independently or in combination, sense various types of touches on the touch screen, such as a short (or tap) touch, a long touch, a multi touch, a drag touch, a flick touch, a pinch-in touch, a pinch-out touch, a swipe touch, or a hovering touch.

The ultrasonic sensor may recognize position information of a sensing object using an ultrasonic wave. The controller 180 may calculate a position of a wave generating source by information sensed by the optical sensor and the plurality of ultrasonic sensors. A position of the wave generating source may be calculated using the property that light is much faster than an ultrasonic wave, that is, the time in which light reaches the optical sensor is much faster than the time in which the ultrasonic wave reaches the ultrasonic sensor. More specifically, the position of the wave generating source may be calculated using a time difference of the time of arrival of the ultrasonic wave with respect to light which serves as a reference signal.

As seen from the configuration of the input interface 120, the camera 121 includes at least one of a camera sensor (for example, a CCD or a CMOS), a photo sensor (or an image sensor), or a laser sensor.

The camera 121 and the laser sensor may be combined to sense a touch of a sensing object for a three-dimensional stereoscopic image. The photo sensor, which is laminated on a display element, is configured to scan a motion of a sensing object proximate to the touch screen. More specifically, the photo sensor is formed by mounting photo diodes and transistors (TR) in rows/columns to scan contents which are disposed on the photo sensor using an electrical signal that changes in accordance with an amount of light applied to the photo diode. That is, the photo sensor calculates coordinates of a sensing object in accordance with a changed amount of light, and position information of the sensing object may be obtained through the coordinates.

The display 151 displays (outputs) information processed in the vehicle display device 100. For example, the display 151 may display execution screen information of an application program executed in the vehicle display device 100, or user interface (UI) or graphic user interface (GUI) information according to the execution screen information.

Further, the display 151 may be configured as a stereoscopic display which displays a stereoscopic image.

A three-dimensional display type such as a stereoscopic type (a glass type), an autostereoscopic type (a glass-free type), a projection type (a holographic type) may be applied to the stereoscopic display.

The speaker 152 may output audio data received from the wireless transceiver 110 or stored in the memory 170 in a call signal reception mode, a phone-call mode, a recording mode, a speech recognition mode, or a broadcasting reception mode. The sound output interface 152 may also output a sound signal related to a function (for example, a call signal reception sound or a message reception sound) performed in the vehicle display device 100. Such a sound output interface 152 may include, for example, a receiver, a speaker, and a buzzer.

The haptic module 153 may generate various tactile effects that can be felt by the user. A representative example of the tactile effect generated by the haptic actuator 153 may be vibration. An intensity and a pattern of the vibration generated in the haptic module 153 may be controlled by the selection of the user or a setting of the controller 180. For example, the haptic module 153 may compose different vibrations to output the composed vibrations, or sequentially output the different vibrations.

In addition to vibration, the haptic module 153 generates various tactile effects such as effects by a pin arrangement which vertically moves to a contact skin surface, an injection force or a suction force of air through an injection port or a suction port, grazing on a skin surface, electrode contact, or stimulation of an electrostatic force or effects of reproducing a cold or hot sensation using a heat absorbing or heat emitting element.

The haptic module 153 may not only transmit a tactile effect by means of direct contact, but may also be implemented to allow the user to feel a tactile effect by muscular sensation of a finger or an arm. Two or more haptic modules 153 may be provided in accordance with the configuration of the vehicle display device 100.

The optical output interface 154 outputs a signal for indicating the occurrence of an event, using light of a light source of the vehicle display device 100. Examples of events generated in the vehicle display device 100 may be message reception, call signal reception, missed call, alarm, schedule notification, email reception, and information reception through an application.

The signal output from the optical output interface 154 is implemented in a form in which the vehicle display device emits single-colored or multi-colored light toward the front surface or the rear surface thereof. When the vehicle display device senses event confirmation by the user, the signal output may be terminated.

The interface 160 serves as a passage between the vehicle display device 100 and all external devices connected to the vehicle display device 100. The interface 160 receives data from the external devices or receives power to transmit data to the respective components in the vehicle display device 100, or transmits data in the vehicle display device 100 to the external devices. For example, the interface 160 may include a wired/wireless headset port, an external charger port, a wired/wireless data port, a memory card port, a port which connects a device equipped with an identification module, an audio input/output (I/O) port, a video input/output (I/O) port, an earphone port, etc.

In the meantime, the identification module is a chip in which various information for authenticating a usage right of the vehicle display device 100 is stored and includes a user identification module (UIM), a subscriber identification module (SIM), and a universal subscriber identity module (USIM). A device with an identification module (hereinafter, "identification device") may be manufactured as a smart card. Therefore, the identification device may be connected to the terminal 100 through the I/O connector 160.

The memory 170 may store a program for an operation of the controller 180, or temporarily store input/output data (for example, a phone book, a message, a still image, a moving image, etc.). The memory 170 may store data on a vibration or a sound of various patterns output when the touch is inputted onto the touch screen.

The memory 170 may include at least one type of storage medium of a flash memory type, a hard disk type, a solid state disk (SSD) type, a silicon disk drive (SDD) type, a multimedia card micro type, and card type memories (for example, SD or XD memory and the like), a random access memory (RAM), a static random access memory (SRAM), a read only memory (ROM), an electrically erasable programmable read only memory (EEPROM), a programmable read only memory (PROM), a magnetic memory, a magnetic disk, and an optical disk. The vehicle display device 100 may operate in association with a web storage which performs a storage function of the memory 170 on the Internet.

As described above, the controller 180 may control an operation related to the application program and an overall operation of the vehicle display device 100. For example, when the state of the vehicle display device satisfies a predetermined condition, the controller 180 may execute or release a locking state which restricts an input of a control command of a user for the applications.

Further, the controller 180 may perform control and processing related to voice call, data communication, and video call, or perform a pattern recognition process which recognizes a handwriting input or a picture drawing input performed on the touch screen as a text or an image, respectively. Moreover, the controller 180 may control any one or a combination of a plurality of components described above to implement various embodiments which will be described below on the vehicle display device 100 according to the present disclosure.

The display 151 displays (outputs) information processed in the vehicle display device 100. For example, the display 151 may display execution screen information of an application program executed in the vehicle display device 100, or user interface (UI) or graphic user interface (GUI) information according to the execution screen information.

The display 151 may include at least one of a liquid crystal display (LCD), a thin film transistor liquid crystal display (TFT LCD), an organic light emitting diode (OLED), a flexible display, a three-dimensional display (3D display), or an electronic ink display (e-ink display).

Further, two or more displays 151 may be provided in accordance with the configuration of the vehicle display device 100. In this case, a plurality of displays may be disposed to be spaced apart from each other or integrally disposed on one surface of the vehicle display device 100 or may be disposed on different surfaces.

The display 151 may include a touch sensor which senses a touch on the display 151 so as to receive the control command by the touch method. Therefore, when the touch is made on the display 151, the touch sensor senses the touch, and based on the touch the controller 180 generates a control command corresponding to the touch. Contents inputted by the touch method may be letters or numbers, instructions in various modes, menu items which may be designated, or the like.

The microphone 122 is configured to receive a voice of the user, or other sounds. The microphone 122 is equipped in a plurality of locations to receive stereo sounds.

The interface 160 serves as a passage through which the vehicle display device 100 is connected to external devices. For example, the interface 160 may be at least one of a connection terminal for connection with other devices (for example, an earphone or an external speaker), a port for short-range communication (for example, an infrared port (IrDA port), a Bluetooth port, a wireless LAN port, etc.), or a power supply terminal for supplying a power to the vehicle display device 100. The interface 160 may be implemented as a socket type which accommodates an external card such as a subscriber identification module (SIM), a user identity module (UIM), and a memory card for information storage.

At least one antenna for wireless communication may be provided in the vehicle display device. The antenna may be embedded in the vehicle display device, or may be formed in a case of the vehicle display device. For example, the antenna which forms a part of the broadcasting receiving module 111 (see FIG. 1) may be configured to be drawn from the vehicle display device. Alternatively, the antenna may be formed as a film type to be attached onto an inner surface of a housing, or a case including a conductive material may serve as an antenna.

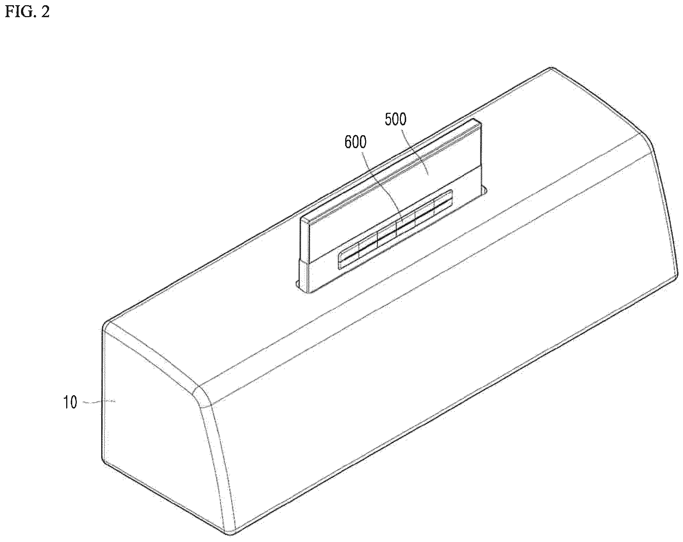

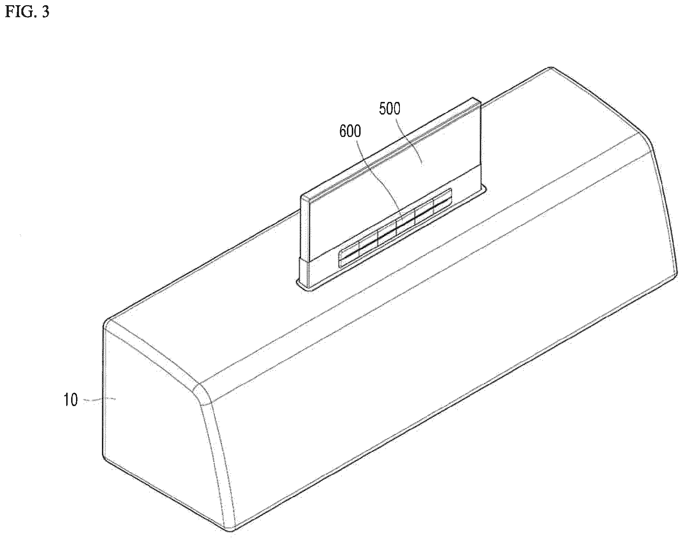

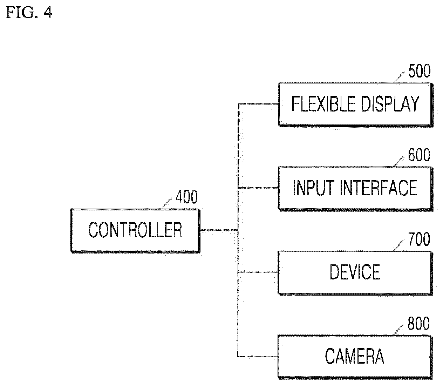

FIG. 2 is a perspective view showing a vehicle display device according to an embodiment. FIG. 3 is a perspective view showing the vehicle display device, the state of which has changed from the state shown in FIG. 2. FIG. 4 is a block diagram for explaining the operation of the vehicle display device according to an embodiment.

The vehicle display device may include a first frame, a second frame, and a flexible display 500.

The first frame may be secured to the dashboard 10 of the vehicle. The second frame may be configured to be movable in the first direction with respect to the first frame.

The externally exposed area of the flexible display 500 may change according to movement of the second frame in the first direction. In this case, the externally exposed area of the flexible display 500 may be defined as the area of the portion of the flexible display 500 that is exposed to the outside of the dashboard 10 and is visible to a driver or a passenger in the vehicle.

For example, the externally exposed area of the flexible display 500 may increase in response to the second frame moving in the first direction away from the first frame secured to the dashboard 10,. Conversely, the externally exposed area of the flexible display 500 may decrease in response to the second frame moving in the first direction close to the first frame.

The concrete structures and operations of the first frame, the second frame and the flexible display 500 will be described in more detail later with reference to the drawings.

The vehicle display device may include an input interface 600 for receiving input for controlling the operation of the flexible display 500. The detailed structure and operation of the input interface 600 are as described.

The input interface 600 may be implemented as a hard key input interface, which is disposed at a predetermined portion of the vehicle. The hard key input interface may be provided, for example, at the dashboard 10 of the vehicle, a portion of the vehicle display device, or any of other appropriate portions in the vehicle so that the user such as the driver conveniently inputs information.

In another embodiment, the input interface 600 may be implemented as a soft key input interface, which is displayed on the flexible display 500. That is, the input interface 600 may be implemented as a soft key input interface displayed on the screen of the flexible display 500 by firmware, applications, etc. installed in the vehicle display device.

The user may input a command to the input interface 600 to increase or decrease the externally exposed area of the flexible display 500.

The externally exposed area of the flexible display 500 may change based on the characteristics of each user or each device 700 included in the vehicle.

Referring to FIG. 4, the controller 400 may be connected to the flexible display 500 and the input interface 600. The structure and operation of the controller 400 areas described herein. The controller 400 may be connected to an actuator for changing the externally exposed area of the flexible display 500. The structure and operation of the actuator will be described in detail later.

The controller 400 may change the externally exposed area of the flexible display 500 according to a command inputted through the input interface 600. For example, when a command for the externally exposed area of the flexible display 500 is input through the input interface 600, the controller 400 may control the actuator in response to the command such that the externally exposed area of the flexible display 500 is changed by the operation of the actuator.

The externally exposed area of the flexible display 500 may be changed based on a control value inputted by the user through the input interface 600. For example, the user may input a preset control value for the externally exposed area of the flexible display 500 through the input interface 600.

In response to a preset control value being inputted, the controller 400 may control the actuator such that the flexible display 500 has an externally exposed area corresponding to the preset control value.

In this case, the preset control value with respect to the externally exposed area may be set so as to be divided into small, medium, and large stages, or may be set to change the horizontal and vertical sizes of the screen of the flexible display 500.

The controller 400 may also be connected to the device 700 provided in the vehicle. The device 700 may be, for example, a navigation system, an air-conditioner, or other driving devices required for driving of the vehicle.

The flexible display 500 may reproduce a screen for control of the device 700 provided in the vehicle, and the externally exposed area of the flexible display 500 may change according to the characteristics of each device 700. According to the characteristics of each device 700, the size of the screen for each device 700 may vary.

For example, the flexible display 500 may reproduce at least one of a navigation screen, a screen for operation of the air-conditioner, a screen for control of the driving device, a screen for video playback, or a screen for manipulation of the audio device.

The controller 400 may perform control such that the externally exposed area of the flexible display 500 varies according to the type of screen reproduced on the flexible display 500. For user convenience, it is necessary to control the size of the screen to vary according to the type of screen reproduced.

When a fuel gauge or a travel speed, for example, are displayed, it may be sufficient to reproduce only numerical values, and it is thus necessary to make the screen relatively small. Therefore, it is appropriate to decrease the externally exposed area of the flexible display 500.

Conversely, when navigation information is displayed, it is necessary to increase the size of the screen so that the driver is capable of accurately and easily recognizing information about the surroundings of, for example, the vehicle of the driver and information about the destination. Therefore, it is appropriate to increase the externally exposed area of the flexible display 500.

When the navigation screen is reproduced, the vehicle display device may maximize the externally exposed area of the flexible display 500. The reason for maximizing the size of the navigation screen is to enable the driver to intuitively and easily recognize information about the surroundings of, for example, the vehicle of the driver and information about the destination, and thus to safely drive the vehicle by allowing the eyes of the driver to be kept on the road without needing to pay too much attention to the navigation screen.

The vehicle display device may further include the camera 800 described above. The camera 800 may be disposed so as to be oriented toward the user in the driver seat. In this case, the camera 800 may be connected to the controller 400.

The controller 400 provided in the vehicle may identify a user seated in the driver seat by recognizing the face of the user using the camera 800, and may control the size of the externally exposed area of the flexible display 500 based on a preset value corresponding to the identified user.

In order to allow the user to conveniently view the flexible display 500, it is necessary to set the size of the externally exposed area of the flexible display 500 differently according to each user based on characteristics such as the physique, height, and tastes of the user.

Each user may set in advance the externally exposed area of the flexible display 500 so as to be suitable for the user in consideration of characteristics such as the physique, height and tastes of the user, and the set value may be stored in the vehicle display device.

The controller 400 may identify a driver seated in the driver seat by recognizing the face of the driver based on information about the image captured by the camera 800, may select a set value corresponding to the identified driver, and may perform control such that the flexible display 500 has an externally exposed area corresponding to the set value.

Conversely, upon receiving a control signal inputted through the input interface 600, the controller 400 may control the size of the externally exposed area of the flexible display 500 based on the control signal inputted through the input interface 600, rather than based on a preset value corresponding to the user identified through the camera 800.

When the user directly inputs the externally exposed area of the flexible display 500 through the input interface 600, it is more appropriate to control the size of the externally exposed area of the flexible display 500 based on the value inputted by the user, rather than based on the set value corresponding to the user identified through the camera 800, in terms of the convenience to the user.

According to the embodiment, upon receiving user input, the controller 400 may perform control such that the flexible display 500 has an externally exposed area corresponding to the user input, thereby providing user convenience.

According to the embodiment, the size of the externally exposed area of the flexible display 500 may be appropriately controlled according to the type of screen displayed, thereby providing user convenience.

According to the embodiment, the flexible display 500 may be controlled such that the size of the externally exposed area thereof varies differently according to each user, thereby providing user convenience.

Hereinafter, the concrete structure and operation of the vehicle display device will be described with reference to the drawings.

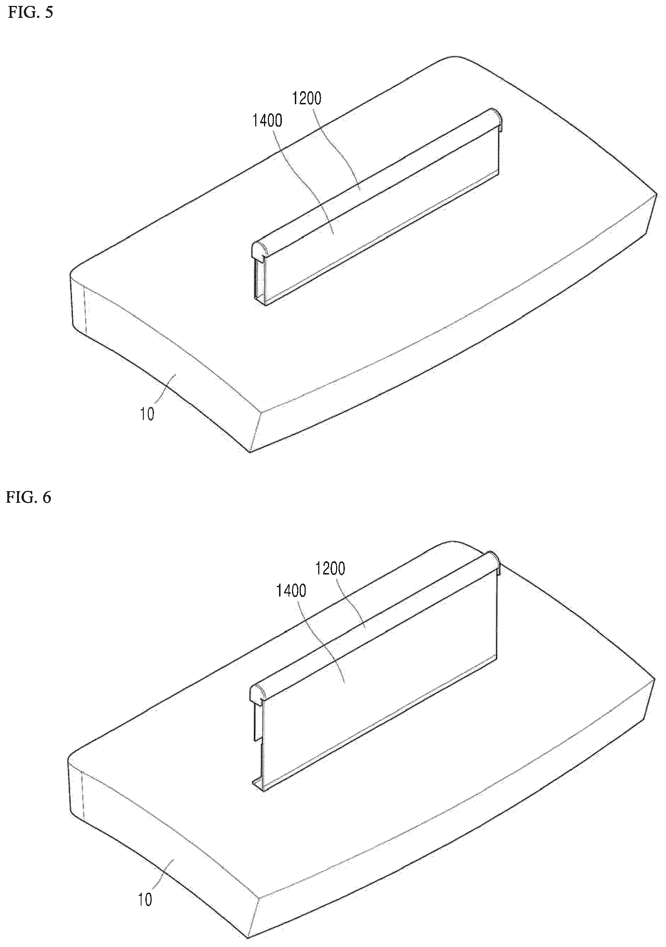

FIG. 5 is a perspective view illustrating a vehicle display device according to an embodiment. FIG. 6 is a perspective view illustrating the vehicle display device, the state of which has changed from the state shown in FIG. 5.

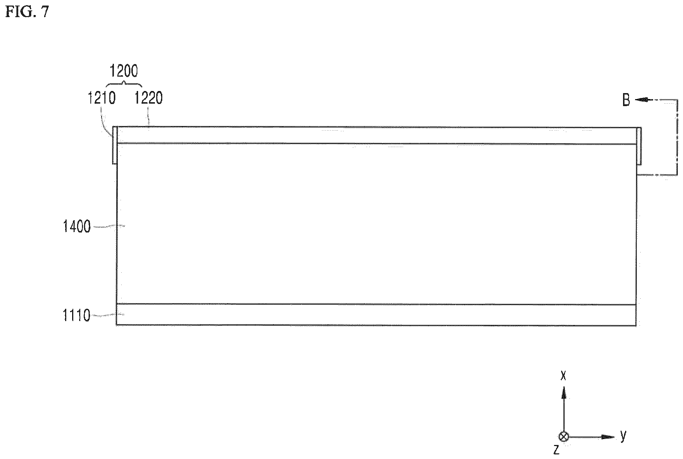

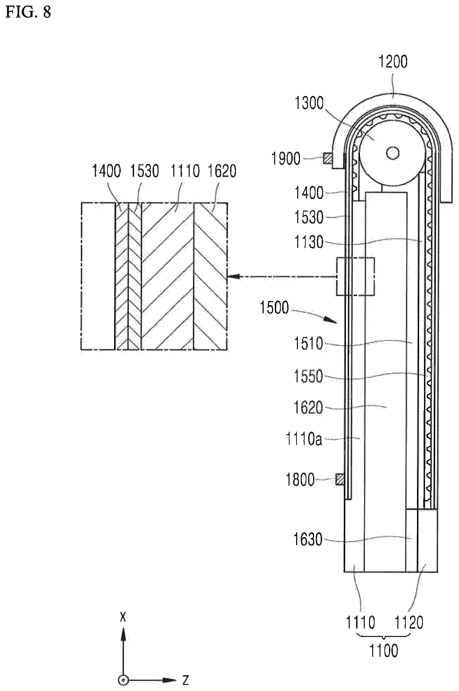

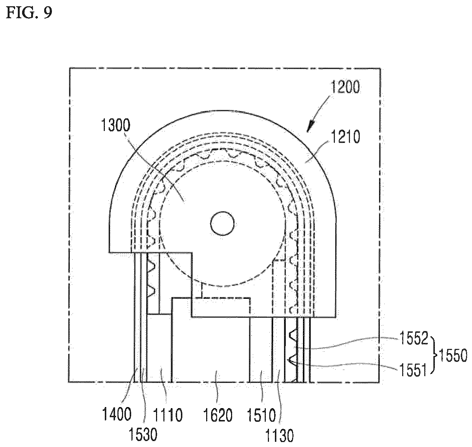

FIG. 7 is a front view illustrating the vehicle display device according to an embodiment. FIG. 8 is a side view of FIG. 7. FIG. 9 is a view of a portion BB in FIG. 7 when viewed from the direction indicated in FIG. 7.

The vehicle display device may include a first frame 1100, a roller 1300, and a flexible display 1400.

The first frame 1100 may be configured to be secured to the dashboard 10 of the vehicle. The dashboard 10 of the vehicle may have a groove formed therein to accommodate the vehicle display device therein, and the first frame 1100 may be disposed at an appropriate position in the groove.

Accordingly, the first frame 1100 may be fixedly coupled to the dashboard 10 in a screw-engagement manner, an interference-fit manner, or any other appropriate coupling manner.

The first frame 1100 may include a front frame 1110 and a rear frame 1120. The front frame 1110 and the rear frame 1120 may be disposed so as to be spaced apart from each other in a direction perpendicular to the first direction, that is, in the z-axis direction, as shown in FIG. 8.

The front frame 1110 may be disposed at the front portion of the vehicle display device. The flexible display 1400 may be coupled to the front frame 1110.

Referring to FIG. 8, the front frame 1110 may include an extension frame 1110a, which has a relatively small thickness, and the flexible display 1400 may be coupled to the front surface of the extension frame 1110a using, for example, an adhesive.

In response to a backplate 1530 not being disposed between the flexible display 1400 and the front frame 1110, the flexible display 1400 and the front frame 1110 may not be in direct contact with each other, or may not be directly coupled to each other.

The rear frame 1120 may be disposed at the rear portion of the vehicle display device, and may be coupled to a second bracket 1620 so as to securely support the second bracket 1620, thereby preventing undesirable movement of the second bracket 1620. For example, the rear frame 1120 may be fixedly coupled to the side surface of the second bracket 1620 so as to support the second bracket 1620.

However, the rear frame 1120 is not an essential component of the vehicle display device. The rear frame 1120 may be eliminated, so long as the front frame 1110 is capable of being coupled to the second bracket 1620 and securely supporting the second bracket 1620 so as to prevent movement of the second bracket 1620.

A second frame 1200 may be provided to be movable in the first direction with respect to the first frame 1100. The roller 1300 may be coupled to the second frame 1200 via a pin so as to be rotatable. In response to the second frame 1200 moving in the first direction, the roller 1300 may also move in the first direction together therewith.

For example, the first direction may be the upward-downward direction of the vehicle or a direction that is inclined at a predetermined angle with respect to the upward-downward direction. The first direction may be a direction substantially parallel to the front surface of the flexible display 1400. The first direction may be appropriately adjusted for the convenience of the driver viewing the flexible display 1400.

The roller 1300 may be rotatably coupled to the second frame 1200, and may move in the first direction according to the movement of the second frame 1200.

Further, the roller 1300 may be formed in the shape of a bar that is disposed such that the longitudinal direction thereof is oriented in a direction perpendicular to the first direction, and may thus support the flexible display 1400 along the width direction of the flexible display 1400, that is, in the direction perpendicular to the first direction.

As shown in FIGS. 7, 8 and 9, the second frame 1200 may include a pair of bodies 1210 and a connection bar 1220.

The roller 1300 may be coupled to the pair of bodies 1210 via a pin such that two opposite end portions of the roller 1300 are supported by the bodies 1210. Accordingly, the roller 1300 may be rotatably coupled to the bodies 1210, and may move together in the first direction according to the movement of the second frame 1200 in the first direction.

The connection bar 1220 may connect the pair of bodies 1210 to each other. In this case, for example, the pair of bodies 1210 and the connection bar 1220 may be integrally formed to each other. In addition, the connection bar 1220 may serve to cause the flexible display 1400 to closely contact the roller 1300.

Referring to FIG. 9, the flexible display 1400 may be disposed in the space formed between the inner surface of the connection bar 1220 and the surface of the roller 1300. The flexible display 1400 may be guided by the inner surface of the connection bar 1220 so as to closely come into contact with the surface of the roller 1300.

The extent to which the flexible display 1400 contacts the surface of the roller 1300 may be adjusted by appropriately adjusting the size of the space. The vehicle display device may be designed such that one surface of the flexible display 1400 directly contacts the surface of the roller 1300. However, in the case in which the backplate 1530 is provided between the flexible display 1400 and the roller 1300, the flexible display 1400 and the roller 1300 may not directly contact each other.

When the backplate 1530 is provided, the size of the space between the inner surface of the connection bar 1220 and the surface of the roller 1300 may be appropriately set in consideration of the thickness of the backplate 1530. The backplate 1530 will be described in detail later.

Referring to FIG. 9, the bodies 1210 may be fixedly coupled to a moving plate 1510. The moving plate 1510 may be configured to be movable in the first direction. In response to the moving plate 1510 moving, the second frame 1200 and the roller 1300 coupled to the second frame 1200 may also move in the first direction together therewith.

The flexible display 1400 may be partially wound around the roller 1300 and bent thereby. One end portion of the flexible display 1400 may be secured to the first frame 1100. As described above, a portion of the flexible display 1400 may be coupled to the extension frame 1110a of the first frame 1100.

The flexible display 1400 may be formed of a flexible material, and may thus be wound around the roller 1300. When wound around the roller 1300, the flexible display 1400 may be bent by the roller 1300.

Accordingly, the portion of the flexible display 1400 that is in close contact with the roller 1300 may be bent, and the remaining portion of the flexible display 1400 may be maintained in a flat planar shape without being bent.

The flexible display 1400 refers to a durable display that is lightweight and is durable, and, while still exhibiting the characteristics of a flat panel display, is fabricated on a thin and flexible substrate that is capable of being warped, bent, folded, twisted, or rolled, like a sheet of paper.

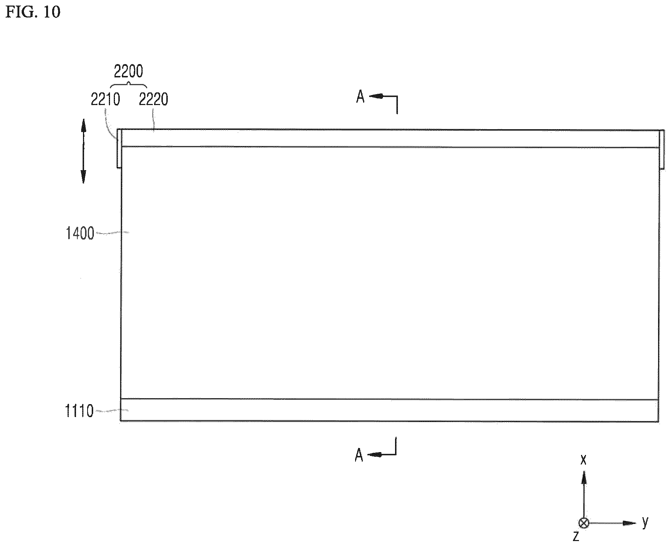

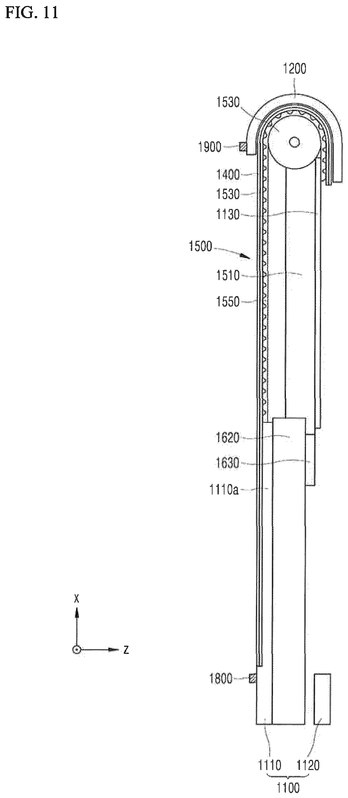

FIG. 10 is a front view showing the vehicle display device, the state of which has changed from the state shown in FIG. 7. FIG. 11 is a side view of FIG. 10.

The flexible display 1400 may be configured such that the externally exposed area of the front surface thereof increases in according with the distance between the first frame 1100 and the roller 1300 increasing. In this case, the externally exposed area of the flexible display 1400 may be defined as the area of the portion of the flexible display 1400 that is exposed to the outside of the dashboard 10 so as to be visible to a driver or a passenger in the vehicle.

FIGS. 5, 7 and 8 illustrate the state in which the externally exposed area of the flexible display 1400 is relatively small. FIGS. 6, 10 and 11 illustrate the state in which the externally exposed area of the flexible display 1400 is relatively large.

The distance between the first frame 1100 and the roller 1300 may increase in response to the roller 1300 moving in the first direction from the state shown in FIG. 8, and the state of the vehicle display device may thus be changed to the state shown in FIG. 11. Accordingly, since one end portion of the flexible display 1400 is secured to the first frame 1100, which does not move in the first direction, the portion of the flexible display 1400 that is secured to the first frame 1100 does not move in the first direction.

As the roller 1300 moves upwards in the first direction away from the first frame 1110, the portion of the flexible display 1400 that is not secured to the first frame 1100 may be spread flat after partially passing through the section in which the flexible display 1400 is bent by the roller 1300.

Due to this structure, the externally exposed area of the flexible display 1400 may increase in response to the roller 1300 moving in the first direction and the distance between the first frame 1100 and the roller 1300 increasing.

In other words, the flexible display 1400 may change from the first state to the second state in response to the roller 1300 moving in the first direction away from the first frame 1100. Conversely, the flexible display 1400 may change from the second state to the first state the roller 1300 moving in the first direction close to the first frame 1100.

For example, FIGS. 5, 7 and 8 illustrate the flexible display 1400 in the first state, and FIGS. 6, 10 and 11 illustrate the flexible display 1400 in the second state.

Referring to the drawings, the externally exposed area of the front surface of the flexible display 1400 in the second state may be greater than that of the front surface of the flexible display 1400 in the first state.

Therefore, due to the above-described structure, the externally exposed area of the flexible display 1400 may decrease in response to the distance between the first frame 1100 and the roller 1300 in the first direction decreasing, and the externally exposed area of the flexible display 1400 may increase in response to the distance between the first frame 1100 and the roller 1300 in the first direction increasing.

The vehicle display device may further include a moving part 1500 and an actuator 1600. The moving part 1500 may serve to move the roller 1300 in the first direction. The actuator 1600 may provide driving force to the moving part 1500.

The moving part 1500 may include a moving plate 1510 and a support bar 1550. However, in another embodiment, a chain 1520 may be used in place of the support bar 1550. The support bar 1550 will be described first, and the chain 1520 will be described later with reference to a separate drawing.

The moving plate 1510 may be formed of a solid material, and one end portion thereof may be fixedly coupled to the second frame 1200. The moving plate 1510 may also move in the first direction together therewith in response to the roller 1300 moving in the first direction,.

Due to the roller 1300 moving in the first direction together with the second frame 1200, the moving plate 1510 may also move in the first direction according to the movement of the second frame 1200 in the first direction.

The support bar 1550 may be coupled at a portion thereof to the first frame 1100. For example, one end of the support bar 1550 and the upper end of the extension frame 1110a of the first frame 1100 may face each other, and may be coupled to each other using an adhesive. The support bar 1550 may have a plate shape overall when spread, however may also be bent by the roller 1300.

In response to the moving plate 1510 moving in the first direction, the support bar 1550 may move in the state in which a portion thereof is wound around the roller 1300. As shown in FIGS. 8 and 11, in response to the roller 1300 moving away from the first frame 1100, the support bar 1550 may move in the first direction close to the roller 1300, may be bent by the roller 1300 such that the moving direction thereof is reversed 180 degrees, and may move in the first direction away from the roller 1300.

Further, the support bar 1550 may be configured to support at least a portion of the rear surface of the flexible display 1400. Referring to FIG. 11, the support bar 1550 may support the rear surface of the flexible display 1400 within the range from the roller 1300 to the portion of the support bar 1550 that is coupled to the extension frame 1110a.

Due to this structure, a portion of the flexible display 1400, for example, the planar portion thereof, may be in close contact with the extension frame 1110a or the support bar 1550.

Similarly, when the chain 1520 is provided in place of the support bar 1550, a portion of the flexible display 1400 may be in close contact with the extension frame 1110a or the chain 1520.

The support bar 1550 may be formed of a flexible material so as to be bendable, and may include a base 1551 and a support portion 1552. The base 1551 and the support portion 1552 may be integrally formed to each other. In another embodiment, the support portion 1552 may be attached to the base 1551 so as to form the support bar 1550. As such, the base 1551 and the support portion 1552 may accordingly be formed of the same material as each other.

The support bar 1550 may be connected at the base 1551 thereof to the roller 1300. The support portion 1552 may be formed in the shape of a bar that has a trapezoidal cross-section and extends in a direction perpendicular to the first direction (refer to FIG. 8).

A plurality of the support portion 1552 may be provided, and the plurality of support portions 1552 may be disposed at regular intervals in the direction in which the support bar 1550 moves. It may be preferable for each support portion 1552 to have a trapezoidal cross-section so as to prevent adjacent ones of the support portions 1552 from interfering with each other when the support bar 1550 is wound around the roller 1300 and bent thereby.

In addition, the moving part 1500 may further include the backplate 1530. The backplate 1530 may be disposed so as to face the flexible display 1400, and at least a portion of the backplate 1530 may be formed as an elastic metal plate.

The flexible display 1400 may be easily curved or bent. In the embodiment, the backplate 1530 may be provided so as to closely contact the rear surface of the flexible display 1400. Accordingly, the backplate 1530 may support the flexible display 1400 so as to secure a planar surface of the flexible display 1400, which is not curved or bent. As a result, the flexible display 1400 may provide a high-quality image to the driver or the like.

Referring to FIGS. 8 and 11, the backplate 1530 may have a size and a shape corresponding to those of the flexible display 1400. The backplate 1530 may be coupled to the flexible display 1400 so as to be integrally movable with the flexible display 1400. The concrete structure of the backplate 1530 will be described in detail later with reference to the drawings.

Referring to FIGS. 8 and 11, the vehicle display device may further include a hall sensor 1800 and a second magnet 1900. The hall sensor 1800 may be secured to the first frame 1100. The second magnet 1900 may be secured to the second frame 1200. Accordingly, the hall sensor 1800 may remain stationary, and the second magnet 1900 may be movable in the first direction together with the second frame 1200. The hall sensor 1800 may be connected to the controller 180.

The hall sensor 1800 may sense the spacing distance to the second magnet 1900, and the controller 180 included in the vehicle display device may determine the externally exposed area of the flexible display 1400 based on the sensed spacing distance to the second magnet 1900.

That is, in response to the second magnet 1900 moving in the first direction, the hall sensor 1800 may sense a change in the magnetic field caused by the second magnet 1900, and the controller 180 may determine, based thereon, the distance between the hall sensor 1800 and the second magnet 1900 in the first direction. Further, the controller 180 may determine the externally exposed area of the flexible display 1400 based on the distance between the hall sensor 1800 and the second magnet 1900 in the first direction.

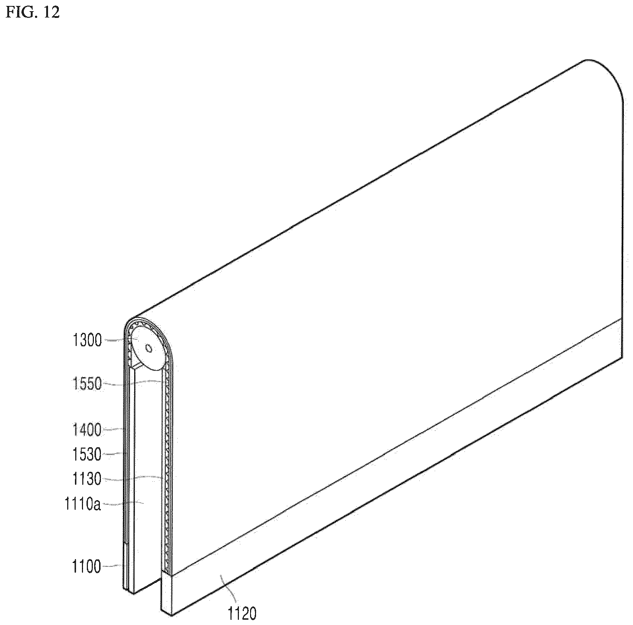

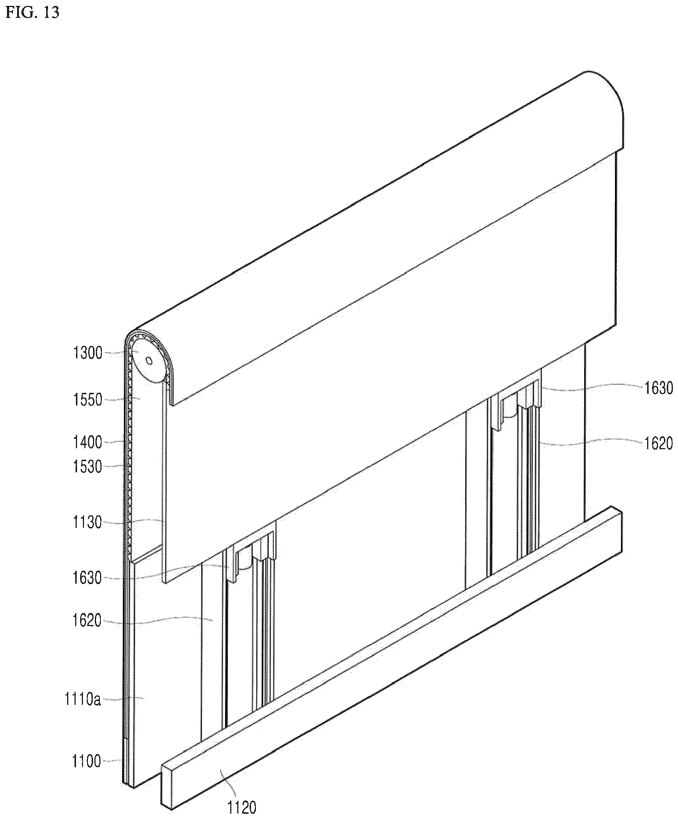

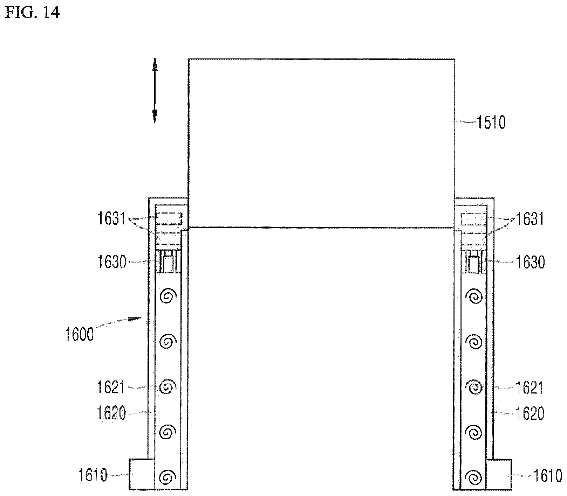

FIG. 12 is a perspective view showing some of the components of the vehicle display device according to an embodiment. FIG. 13 is a perspective view showing the vehicle display device, the state of which has changed from the state shown in FIG. 12. An illustration of some of the components of the vehicle display device is omitted from FIGS. 12 and 13 for clarity of description. FIG. 14 is a view for explaining the actuator 1600 according to an embodiment.

The actuator 1600 may be implemented as a linear motor. However, the disclosure is not limited thereto. In another embodiment, the actuator 1600 may include a driving device, a rack gear provided at the driving device, and a rack gear formed at the moving plate 1510 so as to mesh with the rack gear of the driving device.

Hereinafter, the concrete structure of the actuator 1600, which is implemented as the linear motor, will be described with reference to FIGS. 13 and 14. The actuator 1600 may include a first bracket 1610, a second bracket 1620, and a third bracket 1630.

The first bracket 1610 may be coupled to the first frame 1100. The first bracket 1610 may be integrally formed with the second bracket 1620, or may be separately provided so as to be firmly coupled to the second bracket 1620. The first bracket 1610 may serve to couple the second bracket 1620 to the front frame 1110 of the first frame 1100.

The first bracket 1610 may be coupled to the front frame 1110 using an adhesive or an appropriate fastening mechanism. The second bracket 1620 may be provided as a pair, and accordingly, the first bracket 1610 may also be provided as a pair so as to be capable of being coupled to the pair of second brackets 1620.

The second bracket 1620 may be coupled to the first bracket 1610, and may be disposed such that the longitudinal direction thereof is oriented in the first direction. The second bracket 1620 may have a bar shape and may include a rail that extends in the longitudinal direction thereof in order to guide movement of the third bracket 1630. The third bracket 1630 may be mounted in the rail formed in the second bracket 1620, and may be movable along the rail in the first direction.

The second bracket 1620 may be provided as a pair. Accordingly, the third bracket 1630 may also be provided as a pair so as to be mounted in the pair of second brackets 1620, respectively.

The third bracket 1630 may be coupled to the moving plate 1510, and may be movable in the first direction with respect to the second bracket 1620. As shown in FIG. 14, the third bracket 1630 may be provided as a pair so as to be coupled to the lower end portions of opposite sides of the moving plate 1510, respectively. In this case, the third bracket 1630 may be fixedly coupled to the moving plate 1510.

The third bracket 1630 may be mounted in the rail provided in the second bracket 1620, and may be movable in the first direction with respect to the second bracket 1620. In response to the third bracket 1630 moving in the first direction, the moving plate 1510, to which the third bracket 1630 is secured, may also move in the first direction together therewith.

In response to the moving plate 1510 moving in the first direction, the second frame 1200 and the roller 1300 may also move in the first direction together therewith, and accordingly, the externally exposed area of the flexible display 1400 may increase or decrease.

In order to allow the third bracket 1630 to move in the first direction with respect to the second bracket 1620, a coil 1621 and a third magnet 1631 may be provided. The coil 1621 may be provided in the second bracket 1620, and the third magnet 1631 may be provided in the third bracket 1630.

A plurality of the coils 1621 may be provided inside the second bracket 1620, and the plurality of coils 1621 may be disposed at predetermined intervals in the first direction, and may be configured to receive power. The third magnet 1631 may be provided in a plural number inside the third bracket 1630, and the plurality of third magnets 1631 may be disposed at predetermined intervals in the first direction so as to be opposite the coils 1621.

Based on current flowing through the coil 1621, the third bracket 1630 may be forced to move linearly by the magnetic field formed by the third magnet 1631. Accordingly, the third bracket 1630 may move in the first direction.

The moving distance of the third bracket 1630 in the first direction may be set to be the same as the moving distance of the roller 1300 in the first direction. Since the third bracket 1630 and the second frame 1200 are secured to the moving plate 1510 and the roller 1300 moves in the first direction together with the second frame 1200, the roller 1300 may also move in the first direction the same distance that the third bracket 1630 moves in the first direction.

Due to this structure, the controller 180 may control the moving direction and the moving distance of the third bracket 1630, thereby controlling the moving direction and the moving distance of the roller 1300 and as a result effectively controlling the size of the externally exposed area of the flexible display 1400.

Referring to FIGS. 11 and 13, the vehicle display device may further include a guide plate 1130. The guide plate 1130 may be formed of a solid material that is not deformed, and may be fixedly coupled to the rear surface of the moving plate 1510 so as to be movable in the first direction together with the moving plate 1510.

The guide plate 1130 may serve to prevent the open end portion of the flexible display 1400 or the backplate 1530 from being drawn into the interior of the vehicle display device, that is,. into the space in which the actuator 1600 is disposed, thereby preventing damage to the flexible display 1400 or the backplate 1530.

Therefore, the width of the guide plate 1130 may be set to be greater than the width of the moving plate 1510 and to be equal to or greater than the width of the flexible display 1400 or the width of the backplate 1530.

It is necessary for the upper end of the guide plate 1130 to be disposed adjacent to the roller 1300, and for the lower end of the guide plate 1130 to be disposed adjacent to the rear frame 1120 when the externally exposed area of the flexible display 1400 is minimized. Accordingly, it is necessary for the height of the guide plate 1130, that is, the length thereof in the first direction, to be set appropriately.

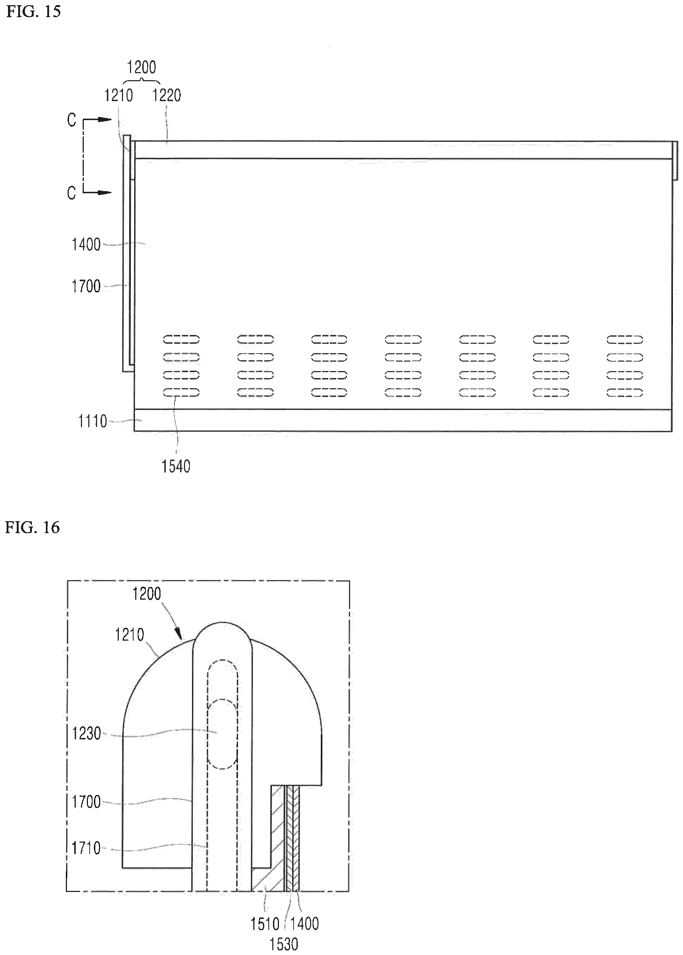

FIG. 15 is a front view showing a vehicle display device according to another embodiment. FIG. 16 is a view of a portion CC in FIG. 15 when viewed from the direction indicated in FIG. 15. The vehicle display device may further include a guide bar 1700.

The guide bar 1700 may be secured to the first frame 1100, such as to the front frame 1110, and may be disposed such that the longitudinal direction thereof is oriented in the first direction. The guide bar 1700 may include a guide rail 1710 to which a protruding portion 1230 of the second frame 1200 is coupled.

Due to the above-described structure, the second frame 1200 and the roller 1300 may be guided by the guide bar 1700 so as to move in the first direction. The guide bar 1700 may be formed of a solid material, and a portion thereof may be secured to the first frame 1100, thereby stably supporting the movement of the second frame 1200 and the roller 1300 in the first direction.

In the embodiment, since the movement of the second frame 1200 and the roller 1300 in the first direction is stably supported by the guide bar 1700, it is possible to effectively prevent wrinkling of the flexible display 1400 or damage thereto, and also to effectively prevent damage to the vehicle display device or malfunction thereof, which may occur when the second frame 1200 and the roller 1300 unstably move in the first direction.

The vehicle display device may further include a first magnet 1540. The first magnet 1540 may be disposed on a portion of the flexible display 1400 in order to couple the flexible display 1400 to the backplate 1530.

As shown in FIG. 15, a plurality of the first magnets 1540 may be provided. The number of first magnets 1540 may be set appropriately such that the first magnets 1540 are arranged horizontally and vertically on a portion of the flexible display 1400. In this case, it is preferable that the first magnets 1540 be disposed on the portion of the flexible display 1400 that is not bent by the roller 1300.

The first magnet 1540 may be attached to, for example, the rear surface of the flexible display 1400, that is, the surface of the flexible display 1400 that faces the backplate 1530, using an adhesive.

In the embodiment, since the flexible display 1400 and the backplate 1530 are securely coupled to each other by the first magnet 1540, it is possible to effectively prevent the backplate 1530 from being pushed from the flexible display 1400 due to repeated movement of the flexible display 1400.

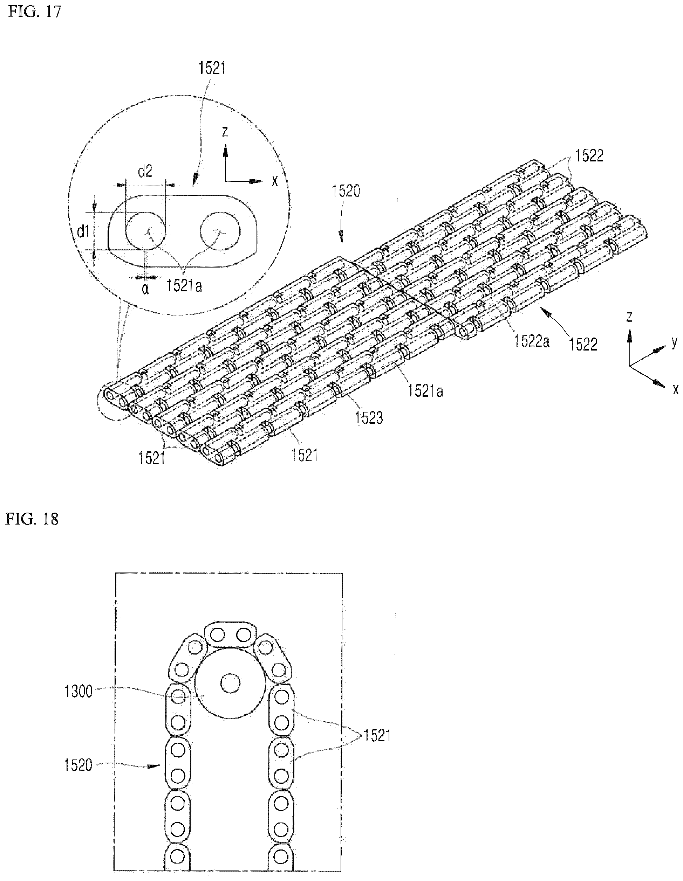

FIG. 17 is a perspective view showing a chain 1520 according to an embodiment. FIG. 18 is a view for explaining the operation of the chain 1520 according to an embodiment.

As described above, the chain 1520 may be provided in place of the support bar 1550, and may serve the same role as the support bar 1550. That is, a portion of the chain 1520 may be coupled to the first frame 1100, for example the extension frame 1110a. Further, the chain 1520 may be bent by the roller 1300, and may support at least a portion of the rear surface of the flexible display 1400.

The chain 1520 may be formed of, for example, a metal material. The chain 1520 may be provided at one end portion thereof with, for example, a pin. The pin may be fitted into the extension frame 1110a so that the chain 1520 and the extension frame 1110a are coupled to each other. However, the coupling method is not limited thereto.

Since the structure of the support bar 1550 has been described above, duplicate descriptions of the chain 1520 and the support bar 1550 are omitted, and the unique structure of the chain 1520 will be described below.

The chain 1520 may include a first link 1521, a second link 1522, and a link pin 1523. The first link 1521 and the second link 1522 may be provided in a plural number.

The plurality of first links 1521 may be arranged in the forward-backward direction, and the plurality of second links 1522 may also be arranged in the forward-backward direction. The first links 1521 and the second links 1522 may be connected to each other.

In order to allow the first link 1521 and the second link 1522 to be connected to each other, the first link 1521 may have a first link hole 1521a formed therein, and the second link 1522 may have a second link hole 1522a formed therein. The link pin 1523 may be fitted into the first link hole 1521a and the second link hole 1522a.

The first link 1521 and the second link 1522 may rotate relative to each other about the link pin 1523 fitted thereinto. The first link 1521 may have two identical first link holes 1521a formed therein so as to be spaced apart from each other. The second link 1522 may have two identical second link holes 1522a formed therein so as to be spaced apart from each other.

The link pin 1523 may be formed to have a circular cross-section, and the second link hole 1522a may also be formed to have a circular cross-section. The first link hole 1521a may be formed in a slot hole shape such that the diameter thereof in the longitudinal direction of the chain 1520 is relatively long. That is, the first link hole 1521a may be formed such that the diameter d2 in the longitudinal direction of the chain 1520 is greater than the diameter d1 in the thickness direction of the chain 1520 (by the length α).

For example, the first link hole 1521a may be formed such that the diameter d2 in the longitudinal direction of the chain 1520 is greater than the diameter d1 in the thickness direction of the chain 1520 by 0.2 mm.

Unlike when the chain 1520 (the combination of links) is in a straight state, when the chain 1520 is curved, for example, when the chain 1520 is bent around the roller 1300, the gaps between some of the links need to increase or decrease in order to enable smooth deformation of the chain 1520. This is because the chain 1520 wound around the roller 1300 is not capable of forming a part of a complete circle (for example, a complete semicircle).

Therefore, in the vehicle display device according to the embodiment, the first link hole 1521a is formed in a slot hole shape such that the diameter thereof in the longitudinal direction of the chain 1520 is relatively long, thereby enabling compensation for the length of the chain 1520.

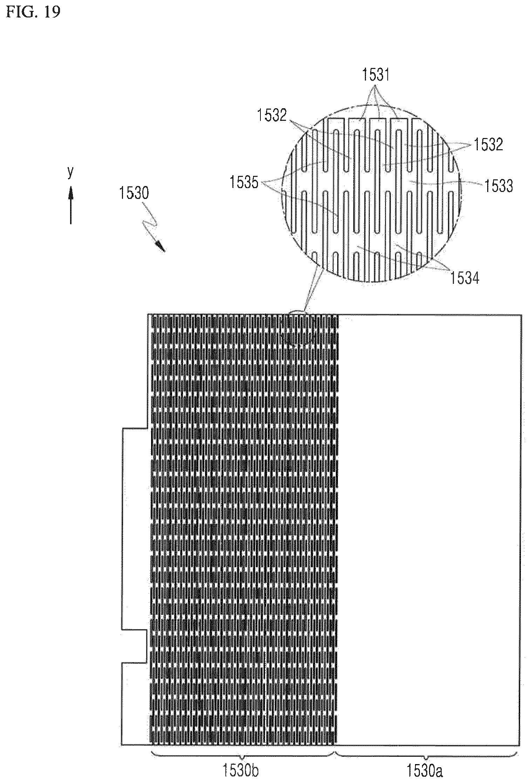

FIG. 19 is a view showing the backplate 1530 according to an embodiment. The backplate 1530 may be formed of a metal plate having elasticity. For example, the backplate 1530 may include a superelastic metal.

The backplate 1530 may allow the flexible display 1400 to be smoothly elastically deformed and elastically restored.

The backplate 1530 may be formed as a relatively thin plate. For example, the backplate 1530 may be formed to have an arbitrary thickness within a range of 0.05 to 0.2 mm, and may be formed to have a thickness of 0.1 mm.

The backplate 1530 may be implemented as a unitary metal plate overall, and may be divided into two or more areas. Specifically, the backplate 1530 may be configured to include a fixed area 1530a and a transformable area 1530b.

The fixed area 1530a is an area that overlaps the portion of the flexible display 1400 that is not bent. In the fixed area 1530a, the backplate 1530 may be formed as a flat metal plate as a whole.

The backplate 1530 may have a through-hole 1535 formed through a portion thereof corresponding to the roller 1300, that is, through the transformable area 1530b. The transformable area 1530b is an area that overlaps the portion of the flexible display 1400 that is bent. A plurality of the through-holes 1535 may be provided, and may be formed through the transformable area 1530b so as to extend in the width direction (the leftward-rightward direction). That is, a plurality of through-holes may be formed through the transformable area 1530b of the backplate 1530 in the thickness direction of the backplate 1530.

In the transformable area 1530b, the backplate 1530 may be formed to be symmetrical in the leftward-rightward direction. The transformable area 1530b in which the plurality of through-holes 1535 are formed may include edges 1531, horizontal connectors 1532, and first vertical connectors 1533.

The edges 1531 are divided into a plurality of edges to form a left edge and a right edge of the backplate 1530. The edges 1531 have a predetermined length in the longitudinal direction, and are spaced apart from each other.

The horizontal connectors 1532 extend from the edges 1531 in the width direction. Two horizontal connectors 1532 extend from one edge 1531.

One first vertical connector 1533 connects two horizontal connectors 1532 extending from different edges 1531. That is, one first vertical connector 1533 connects two horizontal connectors 1532 which extend from two adjacent edges 1531 and are adjacent to each other. The first vertical connectors 1533 may be repeatedly formed along the width direction (the leftward-rightward direction), and the first vertical connectors 1533 may be spaced apart from each other at regular intervals.

Second vertical connectors 1534 may be formed in the transformable area 1530b, and one second vertical connector 1534 connects two horizontal connectors 1532 extending from the same edge 1531. The second vertical connectors 1534 may be repeatedly formed along the width direction (the leftward-rightward direction), and the second vertical connectors 1534 may be spaced apart from each other at regular intervals.

As described above, since the through-holes 1535, which are long in the width direction, are repeatedly formed in the transformable area 1530b, the transformable area 1530b may be easily bent with respect to the rotation axis of the width direction.

When a tensile force, which is an external force, is applied to the transformable area 1530b along the longitudinal direction, the edges 1531 and the first vertical connectors 1533 may be deformed to be spaced apart from each other in the longitudinal direction with respect to the horizontal connectors 1532, and the length of the transformable area 1530b may be increased over the entire area of the transformable area 1530b. When the external force is removed, the transformable area 1530b is elastically recovered to its original state.

Further, when a tensile force, which is an external force, is applied to the transformable area 1530b along the longitudinal direction, the first vertical connectors 1533 and the second vertical connectors 1534 may be deformed to be spaced apart from each other in the longitudinal direction with respect to the horizontal connector 1532, and the length of the transformable area 1530b may be increased over the entire area of the transformable area 1530b. When the external force is removed, the transformable area 1530b is elastically recovered to its original state.

Since the backplate 1530 includes the transformable area 1530b, the region of the flexible display 1400 that is bent may be more flexibly deformed. Therefore, when the flexible display 1400 is bent in a region adjacent to the roller 1300, elastic deformation of the flexible display 1400 is facilitated, and control of springback thereof is also facilitated.

Further, since the backplate 1530 includes the transformable area 1530b, the flexible display 1400 may be elastically deformed within a predetermined range along the longitudinal direction.

In the embodiment, since the externally exposed area of the flexible display 1400 is automatically adjusted by the actuator 1600, it is possible to adjust the size of the screen on which image information is displayed according to user convenience.

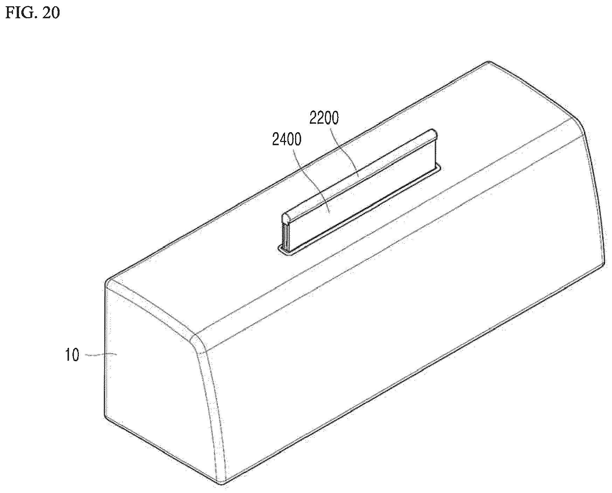

Hereinafter, a vehicle display device having a structure different from that described above with reference to FIGS. 5 to 19 will be described with reference to FIGS. 20 to 37.

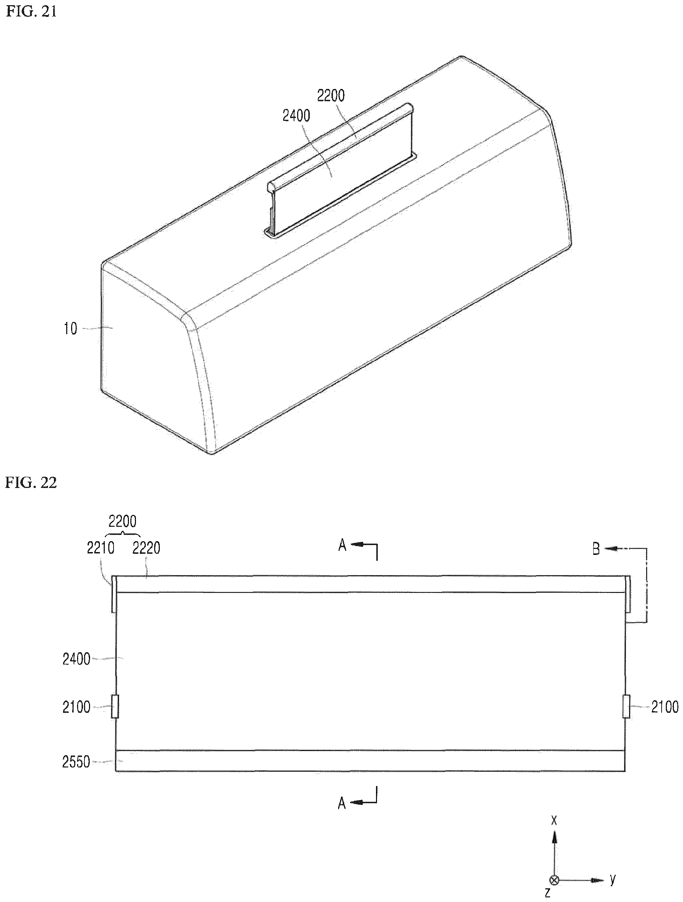

FIG. 20 is a perspective view showing a vehicle display device according to an embodiment. FIG. 21 is a perspective view showing the vehicle display device, the state of which has changed from the state shown in FIG. 20.

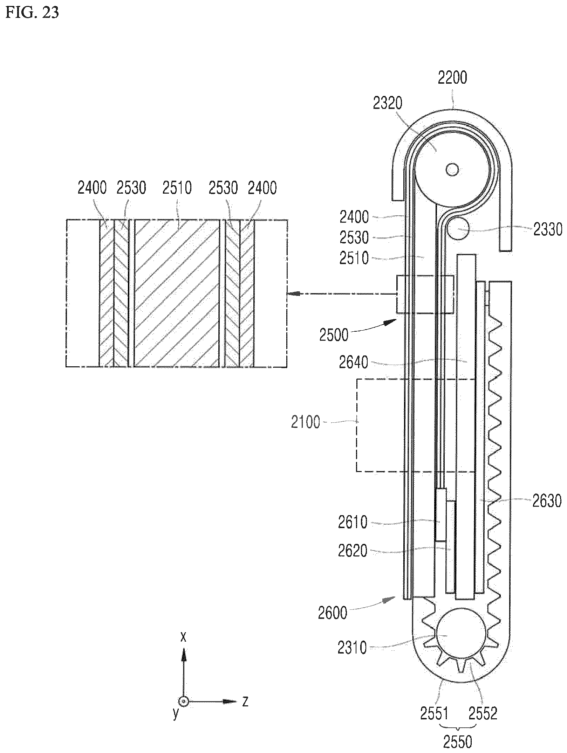

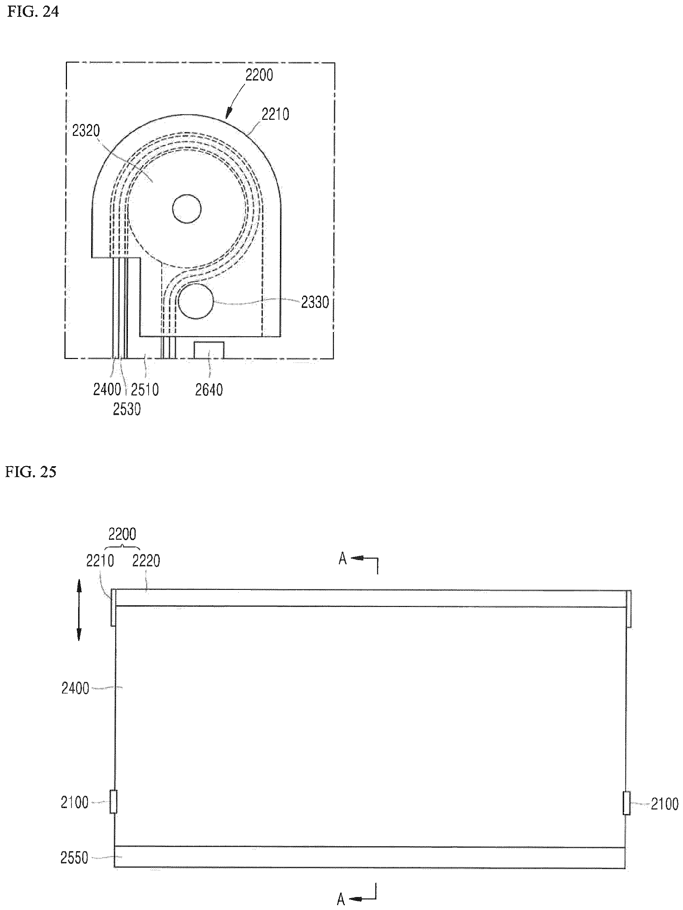

FIG. 22 is a front view showing the vehicle display device according to an embodiment. FIG. 23 is a cross-sectional view of a portion AA in FIG. 22 when viewed from the direction indicated in FIG. 22. FIG. 24 is a view of a portion BB in FIG. 22 when viewed from the direction indicated in FIG. 22.

The vehicle display device may include a first frame 2100, a second frame 2200, a first roller 2310, a second roller 2320, and a flexible display 2400.

The first frame 2100 may be configured to be secured to the dashboard 10 of the vehicle. The dashboard 10 of the vehicle may have a groove formed therein to accommodate the vehicle display device therein, and the first frame 2100 may be disposed at an appropriate position in the groove.

In this case, the first frame 2100 may be fixedly coupled to the dashboard 10 in a screw-engagement manner, an interference-fit manner, or any of other appropriate coupling manners.

The second frame 2200 may be provided to be movable in the first direction with respect to the first frame 2100. The second roller 2320 may be coupled to the second frame 2200 via a pin so as to be rotatable. In response to the second frame 2200 moving in the first direction, the second roller 2320 may also move in the first direction together therewith.

For example, the first direction may be the upward-downward direction of the vehicle or a direction that is inclined at a predetermined angle with respect to the upward-downward direction. The first direction may be a direction substantially parallel to the front surface of the flexible display 2400. The first direction may be appropriately adjusted for the convenience of the driver who views the flexible display 2400.

The first roller 2310 may be disposed so as to be spaced apart from the first frame 2100. The first roller 2310 may not be coupled to the first frame 2100, but may be spaced apart from the first frame 2100 so as to be rotatable.

Further, the first roller 2310 may be formed in the shape of a bar that is disposed such that the longitudinal direction thereof is oriented in a direction perpendicular to the first direction, and may thus support the flexible display 2400, the support bar 2550, or the chain 2520 in the width direction of the flexible display 2400, the support bar 2550, or the chain 2520, that is, in the direction perpendicular to the first direction.

The second roller 2320 may be rotatably coupled to the second frame 2200, and may move in the first direction according to the movement of the second frame 2200.

Further, the second roller 2320 may be formed in the shape of a bar that is disposed such that the longitudinal direction thereof is oriented in a direction perpendicular to the first direction, and may thus support the flexible display 2400 in the width direction of the flexible display 2400, that is, in the direction perpendicular to the first direction.

As shown in FIGS. 22, 23 and 24, the second frame 2200 may include a pair of bodies 2210 and a connection bar 2220.

The second roller 2320 may be coupled to the pair of bodies 2210 via a pin such that two opposite end portions of the second roller 2320 are supported by the bodies 2210. Accordingly, the second roller 2320 may be rotatably coupled to the bodies 2210, and may move together in the first direction according to the movement of the second frame 2200 in the first direction.

The connection bar 2220 may connect the pair of bodies 2210 to each other. Accordingly, for example, the pair of bodies 2210 and the connection bar 2220 may be integrally formed to each other. In addition, the connection bar 2220 may serve to cause the flexible display 2400 to closely contact the second roller 2320.

Referring to FIG. 24, the flexible display 2400 may be disposed in the space formed between the inner surface of the connection bar 2220 and the surface of the second roller 2320. The flexible display 2400 may be guided by the inner surface of the connection bar 2220 so as to closely contact the surface of the second roller 2320.

The extent to which the flexible display 2400 contacts the surface of the second roller 2320 may be adjusted by appropriately adjusting the size of the space. The vehicle display device may be designed such that one surface of the flexible display 2400 directly contacts the surface of the second roller 2320. However, based on the backplate 2530 being provided between the flexible display 2400 and the second roller 2320, the flexible display 2400 and the second roller 2320 may not directly contact each other.

Based on the backplate 2530 being provided, the size of the space between the inner surface of the connection bar 2220 and the surface of the second roller 2320 may be appropriately set in consideration of the thickness of the backplate 2530. The backplate 2530 will be described in detail later.

Referring to FIG. 24, the bodies 2210 may be fixedly coupled to a moving plate 2510. The moving plate 2510 may be configured to be movable in the first direction. In response to the moving plate 2510 moving, the second frame 2200 and the second roller 2320 coupled to the second frame 2200 may also move in the first direction together therewith.

The flexible display 2400 may be partially wound around the second roller 2320 and bent thereby. One end portion of the flexible display 2400 may be secured to the first frame 2100.

The flexible display 2400 may be formed of a flexible material, and may thus be wound around the second roller 2320. When wound around the second roller 2320, the flexible display 2400 may be bent by the second roller 2320.

As such, the portion of the flexible display 2400 that is in close contact with the second roller 2320 may be bent, and the remaining portion of the flexible display 2400 may be maintained in a flat planar shape without being bent. However, the portion of the flexible display 2400 that is in close contact with a third roller 2330, which will be described later, may also be bent by the third roller 2330.

The flexible display 2400 refers to a durable display that is lightweight and durable, and while still exhibiting the characteristics of a flat panel display, is fabricated on a thin and flexible substrate that is capable of being warped, bent, folded, twisted, or rolled, like a sheet of paper.

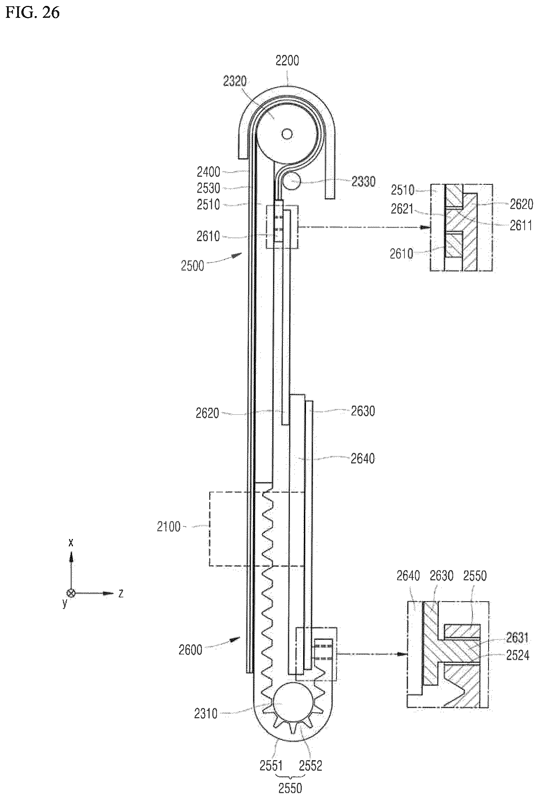

FIG. 25 is a front view showing the vehicle display device, the state of which has changed from the state shown in FIG. 22. FIG. 26 is a cross-sectional view of a portion AA in FIG. 25 when viewed from the direction indicated in FIG. 25.

The flexible display 2400 may be configured such that the externally exposed area of the front surface thereof increases in accordance with the distance between the first roller 2310 and the second roller 2320 increasing. In this case, the externally exposed area of the flexible display 2400 may be defined as the area of the portion of the flexible display 2400 that is exposed to the outside of the dashboard 10 so as to be visible to a driver or a passenger in the vehicle.

FIGS. 20, 22 and 23 illustrate the state in which the externally exposed area of the flexible display 2400 is relatively small. FIGS. 21, 25 and 26 illustrate the state in which the externally exposed area of the flexible display 2400 is relatively large.

In response to the second roller 2320 moving in the first direction from the state shown in FIG. 23, the distance between the first roller 2310 and the second roller 2320 may increase, and the state of the vehicle display device may thus be changed to the state shown in FIG. 26. Accordingly, since one end portion of the flexible display 2400 is secured to the first frame 2100, which does not move in the first direction, the portion of the flexible display 2400 that is secured to the first frame 2100 does not move in the first direction.

As the second roller 2320 moves upwards in the first direction away from the first roller 2310, the portion of the flexible display 2400 that is not secured to the first frame 2100 may be spread flat after partially passing through the section in which the flexible display 2400 is bent by the second roller 2320.

Due to this structure, the externally exposed area of the flexible display 2400 may increase in response to the second roller 2320 moving in the first direction and the distance between the first roller 2310 and the second roller 2320 increasing.

In other words, in response to the second roller 2320 moving in the first direction away from the first roller 2310, the flexible display 2400 may change from the first state to the second state. Conversely, in response to the second roller 2320 moving in the first direction close to the first roller 2310, the flexible display 2400 may change from the second state to the first state.

For example, FIGS. 20, 22 and 23 illustrate the flexible display 2400 in the first state, and FIGS. 21, 25 and 26 illustrate the flexible display 2400 in the second state.

Referring to the drawings, the externally exposed area of the front surface of the flexible display 2400 in the second state may be greater than that of the front surface of the flexible display 2400 in the first state.

Therefore, due to the above-described structure, the externally exposed area of the flexible display 2400 may decrease in response to the distance between the first roller 2310 and the second roller 2320 in the first direction decreasing, and the externally exposed area of the flexible display 2400 may increase in response to the distance between the first roller 2310 and the second roller 2320 in the first direction increasing.

The vehicle display device may further include a moving part 2500 and a guide part 2600. The moving part 2500 may serve to move the second roller 2320 in the first direction. The guide part 2600 may serve to guide the movement of the moving part 2500.

The moving part 2500 may include a moving plate 2510 and a support bar 2550. However, in another embodiment, a chain 2520 may be used in place of the support bar 2550. The support bar 2550 will be described first, and the chain 2520 will be described later with reference to a separate drawing.

The moving plate 2510 may be formed of a solid material, and one end portion thereof may be fixedly coupled to the second frame 2200. In response to the second roller 2320 moving in the first direction, the moving plate 2510 may also move in the first direction together therewith.

Due to the second roller 2320 moving in the first direction together with the second frame 2200, the moving plate 2510 may also move in the first direction according to the movement of the second frame 2200 in the first direction.

The planar surface portion of the flexible display 2400 may be in close contact with one surface of the moving plate 2510. Thus, the planar surface portion of the flexible display 2400 may be maintained by the moving plate 2510.

One end portion of the support bar 2550 may be coupled to the moving plate 2510. The support bar 2550 and the moving plate 2510 may be coupled to each other using, for example, an adhesive. The support bar 2550 may have a plate shape overall when spread, but may also be bent by the first roller 2310.

In response to the moving plate 2510 moving in the first direction, the support bar 2550 may move in the state in which a portion thereof is wound around the first roller 2310. As shown in FIGS. 23 and 26, as the second roller 2320 moves away from the first roller 2310, the support bar 2550 may move in the first direction close to the first roller 2310, may be bent by the first roller 2310 such that the moving direction thereof is reversed 180 degrees, and may move in the first direction away from the first roller 2310.

Further, the support bar 2550 may be configured to support at least a portion of the rear surface of the flexible display 2400. Referring to FIG. 26, as the second roller 2320 moves in the first direction away from the first roller 2310, a portion of the support bar 2550, that is, a portion adjacent to the portion coupled to the moving plate 2510, may be bent by the first roller 2310, and the moving direction changes so as to move in the same direction as the second roller 2320, thereby supporting a portion of the rear surface of the flexible display 2400.

Due to this structure, a portion of the flexible display 2400, for example, the planar portion thereof, may be in close contact with the moving plate 2510 or the support bar 2550.

Similarly, based on the chain 2520 being provided in place of the support bar 2550, a portion of the flexible display 2400 may be in close contact with the moving plate 2510 or the chain 2520.

The support bar 2550 may be formed of a flexible material so as to be bendable, and may include a base 2551 and a support portion 2552. The base 2551 and the support portion 2552 may be integrally formed to each other. In another embodiment, the support portion 2552 may be attached to the base 2551 so as to form the support bar 2550. As such, the base 2551 and the support portion 2552 may accordingly be formed of the same material as each other.

The support bar 2550 may be connected at the base 2551 thereof to the first roller 2310. The support portion 2552 may be formed in the shape of a bar that has a trapezoidal cross-section and extends in a direction perpendicular to the first direction (refer to FIG. 23).

A plurality of the support portions 2552 may be provided, and the plurality of support portions 2552 may be disposed at regular intervals in the direction in which the support bar 2550 moves. It may be preferable for each support portion 2552 to have a trapezoidal cross-section so as to prevent adjacent ones of the support portions 2552 from interfering with each other when the support bar 2550 is wound around the first roller 2310 and bent thereby.

The vehicle display device may further include a third roller 2330. The third roller 2330 may be rotatably coupled to the second frame 2200, and may support the flexible display 2400 such that a portion of the flexible display 2400 is in close contact with the moving plate 2510.

Further, the third roller 2330 may be formed in the shape of a bar that is disposed such that the longitudinal direction thereof is oriented in a direction perpendicular to the first direction, and may thus support the flexible display 2400 in the width direction of the flexible display 2400, that is, in the direction perpendicular to the first direction.

As shown in FIGS. 23 and 26, the second roller 2320 and the third roller 2330 may be spaced apart from each other, and a space may be formed therebetween. The flexible display 2400 may be disposed in this space so as to pass therethrough.

Due to this structure, the flexible display 2400 may be supported by the second roller 2320 and the third roller 2330, and the flexible display 2400 may be more effectively attached to the moving plate 2510.

The flexible display 2400 may be easily curved or bent. In the embodiment, the flexible display 2400 is in close contact with the moving plate 2510 using the second roller 2320 and the third roller 2330. Accordingly, the portion of the flexible display 2400 that corresponds to the moving plate 2510 may be maintained to be a planar surface that is not curved or bent. As a result, the flexible display 2400 may provide a high-quality image to, for example, the driver.

The third roller 2330 may be rotatably coupled to the body 2210 of the second frame 2200 together with the second roller 2320. Therefore, when the second roller 2320 moves in the first direction, the third roller 2330 may move in the first direction together with the second roller 2320. Accordingly, the spacing distance between the second roller 2320 and the third roller 2330 may be maintained constant regardless of the movement thereof in the first direction.

Due to this structure, the second roller 2320 and the third roller 2330 may effectively cause the flexible display 2400 to closely contact the moving plate 2510 regardless of the externally exposed area of the flexible display 2400 increasing or decreasing according to the movement of the second roller 2320 in the first direction.

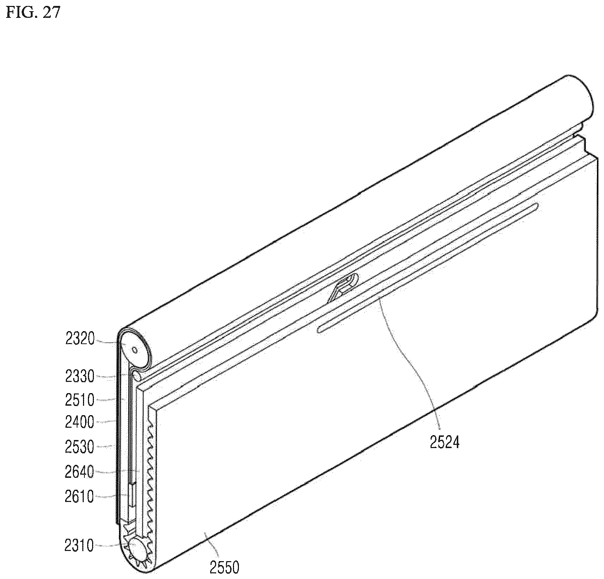

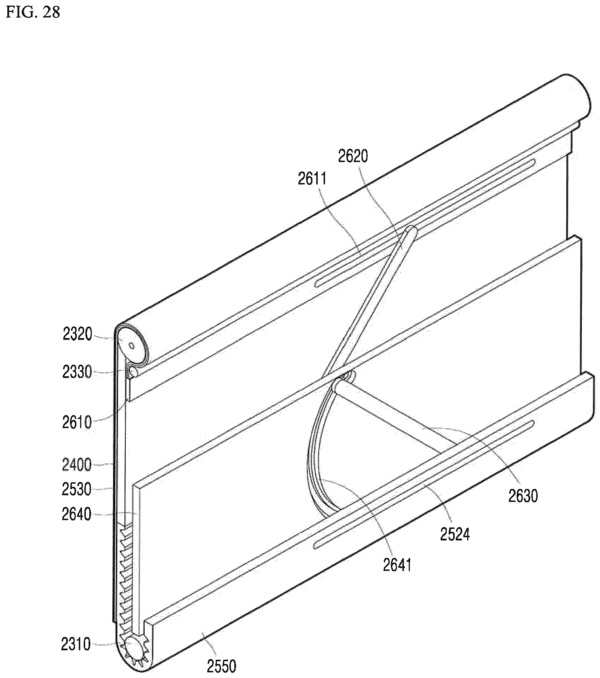

FIG. 27 is a perspective view showing some of the components of the vehicle display device according to an embodiment. FIG. 28 is a perspective view showing the vehicle display device, the state of which has changed from the state shown in FIG. 27. An illustration of some of the components of the vehicle display device is omitted from FIGS. 27 and 28 for clarity of description.

Referring to FIGS. 27 and 28, the guide part 2600 may include a connector 2610, a first control bar 2620, a second control bar 2630, and an inner plate 2640.

The connector 2610 may be coupled to one end of the flexible display 2400. The flexible display 2400 may be coupled to the connector 2610 using, for example, an adhesive. The connector 2610 may move in the first direction according to rotation of the first control bar 2620.

As shown in FIGS. 27 and 28, the connector 2610 may be disposed such that the longitudinal direction thereof is oriented in the direction perpendicular to the first direction. The connector 2610 may serve to guide the flexible display 2400 such that the flexible display 2400 moves in the first direction while remaining at a constant position in the width direction thereof, that is, in the direction perpendicular to the first direction.

The externally exposed area of the flexible display 2400 may decrease in response to the connector 2610 moving close to the first roller 2310. Conversely, the externally exposed area of the flexible display 2400 may increase in response to the connector 2610 moving away from the first roller 2310,.

One end of the first control bar 2620 may be coupled to the connector 2610. The first control bar 2620 may be disposed to be movable in the direction perpendicular to the first direction with respect to the connector 2610. In addition, the first control bar 2620 may be configured to rotate according to the movement of the second roller 2320 in the first direction.

The first control bar 2620 may rotate in the clockwise direction or in the counterclockwise direction and may pull the connector 2610 in response to the second roller 2320 moving in the first direction away from or close to the first roller 2310,.

The first control bar 2620 may pull the connector 2610 regardless of the position of the second roller 2320 in the first direction, thereby increasing the extent to which the flexible display 2400 closely contacts the moving plate 2510, the second roller 2320, or the third roller 2330.

One end of the second control bar 2630 may be coupled to the opposite end of the first control bar 2620. The second control bar 2630 may be configured to rotate when the second roller 2320 moves in the first direction. The first control bar 2620 and the second control bar 2630 may be rotatably coupled to each other.

The opposite end of the second control bar 2630 may be coupled to an end portion of the support bar 2550 or the chain 2520. In response to the second roller 2320 moving in the first direction away from or close to the first roller 2310, the second control bar 2630 may rotate in the clockwise direction or in the counterclockwise direction and may pull the support bar 2550 or the chain 2520.

The second control bar 2630 may pull the support bar 2550 or the chain 2520 regardless of the position of the second roller 2320 in the first direction, thereby increasing the extent to which the support bar 2550 or the chain 2520 closely contacts the first roller 2310.

In order for the first control bar 2620 to pull the connector 2610 and in order for the second control bar 2630 to pull the support bar 2550 or the chain 2520, the first control bar 2620 and the second control bar 2630 need to have restoring force so as to rotate in a direction in which the angle between the first control bar 2620 and the second control bar 2630 decreases.

To this end, a second elastic part 2720 may be disposed at the coupling portion between the first control bar 2620 and the second control bar 2630. The second elastic part 2720 may be described in detail later with reference to the drawings.

The inner plate 2640 may be secured to the first frame 2100, and the coupling portion between the first control bar 2620 and the second control bar 2630 may penetrate the inner plate 2640. The inner plate 2640 may have a second slot 2641 formed therein, which will be described later. The inner plate 2640 may guide the movement of the coupling portion between the first control bar 2620 and the second control bar 2630 using the second slot 2641.

In order to guide rotation and movement of the first frame 2100 and the second frame 2200, a first slot 2611, a second slot 2641, and a third slot 2524 may be provided.

The connector 2610 may include the first slot 2611, which is formed such that the longitudinal direction thereof is oriented in the direction perpendicular to the first direction. A first protrusion 2621 protruding from one end of the first control bar 2620 may be inserted into the first slot 2611. Thus, the movement of the first control bar 2620 with respect to the connector 2610 may be guided by the first slot 2611.

Accordingly, one end of the first control bar 2620 may be coupled to the first slot 2611 so as to be movable in the direction perpendicular to the first direction, and may be guided and moved by the first slot 2611.

The inner plate 2640 may include the second slot 2641, into which the coupling portion between the first control bar 2620 and the second control bar 2630 is inserted. Thus, the movement of the coupling portion between the first control bar 2620 and the second control bar 2630 may be guided by the second slot 2641.

The first control bar 2620 and the second control bar 2630 may be coupled to each other at a coupling portion so as to be rotatable relative to each other. The coupling portion may be guided and moved on the inner plate 2640 by the second slot 2641, which is formed through the inner plate 2640.

The second slot 2641 may be formed to have an appropriate curvature in consideration of the designed movement of the first control bar 2620 and the second control bar 2630.

The support bar 2550 or the chain 2520 may include the third slot 2524, which is formed such that the longitudinal direction thereof is oriented in the direction perpendicular to the first direction. A second protrusion 2631 protruding from one end of the second control bar 2630 may be inserted into the third slot 2524. Thus, the movement of the second control bar 2630 with respect to the chain 2520 may be guided by the third slot 2524.

Accordingly, one end of the second control bar 2630 may be coupled to the third slot 2524 so as to be movable in the direction perpendicular to the first direction, and may be guided and moved by the third slot 2524.

In addition, the moving part 2500 may further include the backplate 2530. The backplate 2530 may be disposed so as to face the flexible display 2400, and at least a portion of the backplate 2530 may be formed as an elastic metal plate.

The flexible display 2400 may be easily curved or bent. In the embodiment, the backplate 2530 may be provided so as to closely contact the rear surface of the flexible display 2400. Accordingly, the backplate 2530 may support the flexible display 2400 so as to secure a planar surface of the flexible display 2400, which is not curved or bent. As a result, the flexible display 2400 may provide a high-quality image to, for example, the driver.

Referring to FIGS. 23 and 26, the backplate 2530 may have a size and a shape corresponding to those of the flexible display 2400. The backplate 2530 may be coupled to the flexible display 2400 so as to be integrally movable with the flexible display 2400. The concrete structure of the backplate 2530 will be described in detail later with reference to the drawings.

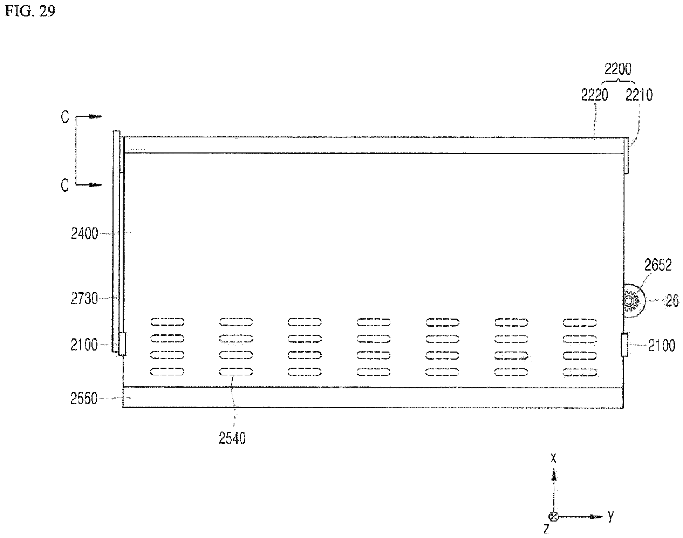

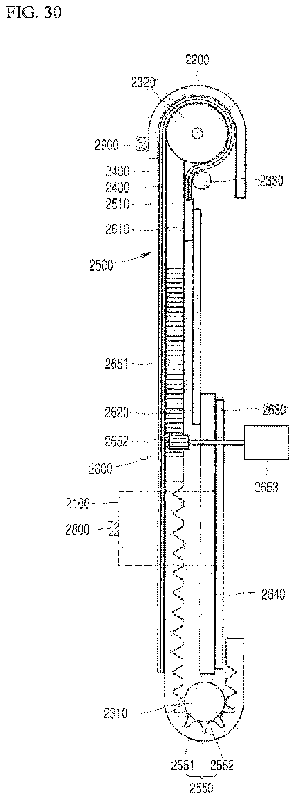

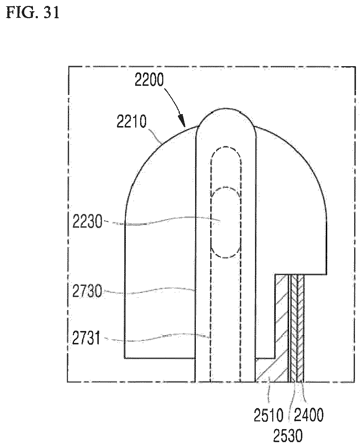

FIG. 29 is a front view showing a vehicle display device according to another embodiment. FIG. 30 is a side view of FIG. 29. FIG. 31 is a view of a portion CC in FIG. 29 when viewed from the direction indicated in FIG. 29.

As shown in FIGS. 29 and 31, the vehicle display device may further include a guide bar 2730. The guide bar 2730 may be secured to the first frame 2100, and may be disposed such that the longitudinal direction thereof is oriented in the first direction. The guide bar 2730 may include a guide rail 2731 to which a protruding portion 2230 of the second frame 2200 is coupled.

Due to the above-described structure, the second frame 2200 and the second roller 2320 may be guided by the guide bar 2730 so as to move in the first direction. The guide bar 2730 may be formed of a solid material, and a portion thereof may be secured to the first frame 2100, thereby stably supporting the movement of the second frame 2200 and the second roller 2320 in the first direction.

In the embodiment, since the movement of the second frame 2200 and the second roller 2320 in the first direction is stably supported by the guide bar 2730, it is possible to effectively prevent wrinkling of the flexible display 2400 or damage thereto. It is also possible effectively prevent damage to the vehicle display device or malfunction thereof, which may occur when the second frame 2200 and the second roller 2320 unstably move in the first direction.

The moving part 2500 may further include a first magnet 2540. The first magnet 2540 may be disposed on a portion of the flexible display 2400 in order to couple the flexible display 2400 to the backplate 2530.

As shown in FIG. 29, a plurality of the first magnets 2540 may be provided. The number of first magnets 2540 may be set appropriately such that the first magnets 2540 are arranged horizontally and vertically on a portion of the flexible display 2400. In this case, it is preferable that the first magnets 2540 be disposed on the portion of the flexible display 2400 that is not bent by the second roller 2320.

The first magnet 2540 may be attached to, for example, the rear surface of the flexible display 2400, that is, the surface of the flexible display 2400 that faces the backplate 2530, using an adhesive.

In the embodiment, since the flexible display 2400 and the backplate 2530 are securely coupled to each other by the first magnet 2540, it is possible to effectively prevent the backplate 2530 from being pushed from the flexible display 2400 due to repeated movement of the flexible display 2400.

In the vehicle display apparatus, the size of the externally exposed area of the flexible display 2400 may be manually changed by, for example, the driver. For example, when the driver pushes the front surface of the flexible display 2400 upwards, the first roller 2310 may ascend, and the externally exposed area of the flexible display 2400 may increase. Conversely, when the driver pulls the front surface of the flexible display 2400 downwards, the first roller 2310 may descend, and the externally exposed area of the flexible display 2400 may decrease.

In order to facilitate the operation of the vehicle display device, it is necessary to appropriately adjust the magnitude of the restoring force of the second elastic part 2720.

In another embodiment, the vehicle display device may include an actuator 2650 for automatically changing the size of the externally exposed area of the flexible display 2400. As shown in FIGS. 29 and 30, the vehicle display device may further include an actuator 2650 for operating the guide part 2600. The actuator 2650 may include a rack gear 2651, a pinion gear 2652, and a motor 2653.

The rack gear 2651 may be formed on the moving plate 2510, and may be disposed such that the longitudinal direction thereof is oriented in a direction parallel to the first direction. The pinion gear 2652 may be disposed so as to mesh with the rack gear 2651. In this case, in order to maintain the engagement between the pinion gear 2652 and the rack gear 2651, a casing for causing the pinion gear 2652 and the rack gear 2651 to closely contact each other may be provided.

The motor 2653 may be provided to rotate the pinion gear 2652. The motor 2653 may be fixedly mounted in the space of the dashboard 10 of the vehicle or the vehicle display device.

The pinion gear 2652 may be disposed on the rotary shaft of the motor 2653. When the pinion gear 2652 is rotated via rotation of the motor 2653, the rack gear 2651, which meshes with the pinion gear 2652, may move in the first direction, and accordingly the moving plate 2510, on which the rack gear 2651 is formed, may move in the first direction.

In response to the pinion gear 2652 rotating, the moving plate 2510 may move in the first direction, and the first control bar 2620 and the second control bar 2630 may rotate relative to each other about the coupling portion therebetween.

That is, in response to the moving plate 2510 moving in the first direction, the second frame 2200 and the second roller 2320 may move in the first direction, and accordingly the externally exposed area of the flexible display 2400 may increase or decrease.

The controller 180 provided in the vehicle display device may be electrically connected to the motor 2653 to control the operation of the motor 2653. Accordingly, the increase or decrease in the externally exposed area of the flexible display 2400 may be controlled by the controller 180.

The vehicle display device may further include a hall sensor 2800 and a second magnet 2900. The hall sensor 2800 may be secured to the first frame 2100. The second magnet 2900 may be secured to the second frame 2200. Accordingly, the hall sensor 2800 may remain stationary, and the second magnet 2900 may be movable in the first direction together with the second frame 2200. The hall sensor 2800 may be connected to the controller 180.

The hall sensor 2800 may sense the spacing distance to the second magnet 2900, and the controller 180 included in the vehicle display device may determine the externally exposed area of the flexible display 2400 based on the sensed spacing distance to the second magnet 2900.

That is, in response to the second magnet 2900 moving in the first direction, the hall sensor 2800 may sense a change in the magnetic field caused by the second magnet 2900, and the controller 180 may determine, based thereon, the distance between the hall sensor 2800 and the second magnet 2900 in the first direction. Further, the controller 180 may determine the externally exposed area of the flexible display 2400 based on the distance between the hall sensor 2800 and the second magnet 2900 in the first direction.

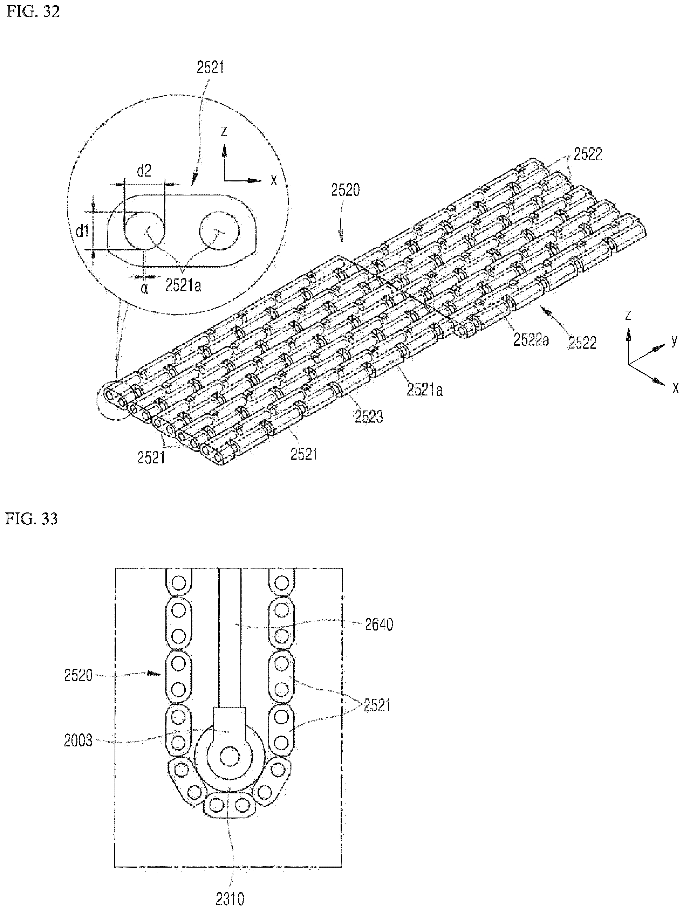

FIG. 32 is a perspective view showing a chain 2520 according to an embodiment. FIG. 33 is a view for explaining the operation of the chain 2520 according to an embodiment.

As described above, the chain 2520 may be provided in place of the support bar 2550, and may serve the same role as the support bar 2550. That is, one end portion of the chain 2520 may be coupled to the moving plate 2510. Further, the chain 2520 may be bent by the first roller 2310, and may support at least a portion of the rear surface of the flexible display 2400.

The chain 2520 may be formed of, for example, a metal material. The chain 2520 may be provided at one end portion thereof with, for example, a pin. The pin may be fitted into the moving plate 2510 so that the chain 2520 and the moving plate 2510 are coupled to each other. However, the coupling method is not limited thereto.

Since the structure of the support bar 2550 has been described above, duplicate descriptions of the chain 2520 and the support bar 2550 may be omitted, and the unique structure of the chain 2520 will be described below.

The chain 2520 may include a first link 2521, a second link 2522, and a link pin 2523. A plurality of first links 2521 and a plurality of second links 2522 are provided.

The plurality of first links 2521 may be arranged in the forward-backward direction, and the plurality of second links 2522 may also be arranged in the forward-backward direction. The first links 2521 and the second links 2522 may be connected to each other.

In order to allow the first link 2521 and the second link 2522 to be connected to each other, the first link 2521 may have a first link hole 2521a formed therein, and the second link 2522 may have a second link hole 2522a formed therein. The link pin 2523 may be fitted into the first link hole 2521a and the second link hole 2522a.

The first link 2521 and the second link 2522 may relatively rotate, with the link pin 2523 that fastens them serving as a rotational axis. In the first link 2521, two identical first link holes 2521a are formed to be spaced apart from each other, and in the second link 2522, two identical second link holes 2522a are formed to be spaced apart from each other.

The link pin 2523 has a circular shape in cross-section, and the second link hole 2522a also has a circular shape in cross-section. In this case, the first link hole 2521a may be formed to have a long hole shape with a longer diameter in the longitudinal direction of the chain 2520. That is, the first link hole 2521a is formed such that a diameter d2 of the longitudinal direction is greater than a diameter d1 of the thickness direction (by α).

For example, the first link hole 2521a may be formed such that the diameter d2 in the longitudinal direction of the chain 2520 is greater than the diameter d1 in the thickness direction of the chain 2520 by 0.2 mm.

Unlike when the chain 2520 (a combination of links) is straight, when the chain 2520 is bent, for example when the chain 2520 is bent around the first roller 2310, for a smooth deformation of the chain 2520, the intervals between some links need to be spaced apart from each other, or the intervals between some links need to be close to each other. This is because the chain 2520 that is wound around the first roller 2310 cannot form a part of a complete circle (for example, a complete semicircle).

Therefore, in the vehicle display device according to the embodiment, the first link hole 2521a is formed in a slot hole shape such that the diameter thereof in the longitudinal direction of the chain 2520 is relatively long, thereby enabling compensation for the length of the chain 2520.

The vehicle display device according to the embodiment may further include a third frame 2003. Referring to FIG. 33, the third frame 2003 may be fixedly coupled to the lower end of the inner plate 2640, and the first roller 2310 may be rotatably coupled to the third frame 2003.

For example, the third frame 2003 may be provided in a pair so as to be fixedly coupled to the lower end portions of opposite sides of the inner plate 2640, respectively. Two opposite ends of the first roller 2310 may be rotatably coupled to the pair of third frames 2003.

The first roller 2310 may be rotatably coupled to the inner plate 2640, which does not move in the first direction, by the third frame 2003. Thus, the chain 2520 may move in the first direction while being bent by the first roller 2310 and stably supported thereby.

This structure of the third frame 2003 may also be applied to the vehicle display device having the support bar 2550.

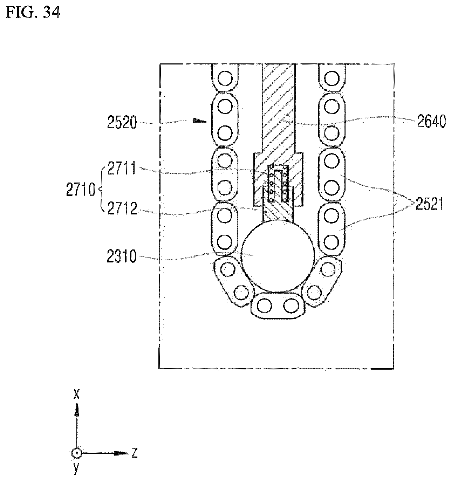

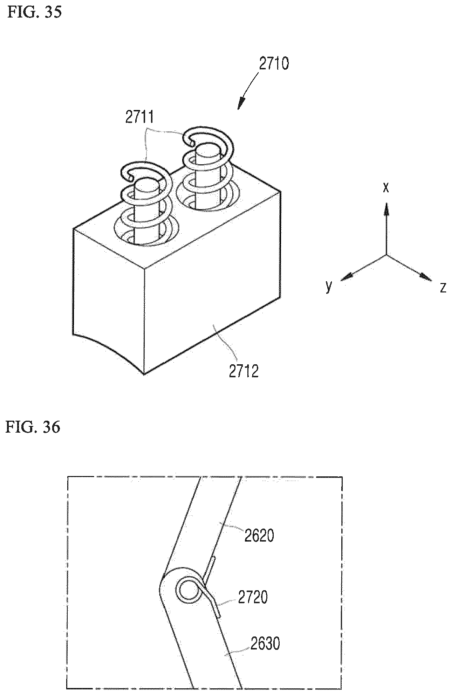

A first elastic part 2710 may be used in place of the third frame 2003 in order to support the first roller 2310. FIG. 34 is a view for explaining the operation of the first elastic part 2710 according to an embodiment. FIG. 35 is a perspective view showing the first elastic part 2710 according to an embodiment.

The vehicle display device may include the first elastic part 2710 in place of the third frame 2003. The first elastic part 2710 may be mounted on the inner plate 2640. Specifically, the first elastic part 2710 may be disposed between the inner plate 2640 and the first roller 2310, and may elastically support the second roller 2320.

The first elastic part 2710 may include an elastic body 2711 and a pusher 2712. The pusher 2712 may have a protrusion for mounting the elastic body 2711 thereon. Referring to FIG. 34, the inner plate 2640 may have a hole formed in the lower end thereof, into which the elastic body 2711 and the protrusion of the pusher 2712 are inserted.

For example, the elastic body 2711 may have a form such as that of a coil spring The elastic body 2711 is configured to store an elastic force in a compressed state, and apply pressure to the first roller 2310 in this state.

The elastic body 2711 may be configured to press the first roller 2310 via the pusher 2712. In another embodiment, only the elastic body 2711 may be mounted on the lower end of the inner plate 2640 to press the first roller 2310 without using the pusher 2712.

The first roller 2310 may be pressed to closely contact the chain 2520 by the first elastic part 2710. Thus, the chain 2520 may move in the first direction while being bent by the first roller 2310 and stably supported thereby.

The abovementioned structure of the first elastic part 2710 may also be applied to the vehicle display device having the support bar 2550.

The guide part 2600 may further include a second elastic part 2720. FIG. 36 is a view for explaining the operation of the second elastic part 2720 according to an embodiment.

The second elastic part 2720 may be disposed at the coupling portion between the first control bar 2620 and the second control bar 2630 in order to elastically support rotation of the first control bar 2620 and the second control bar 2630.

For example, the second elastic part 2720 may be implemented as a torsion spring. The second elastic part 2720 may be mounted so as to penetrate the coupling portion about which the first control bar 2620 and the second control bar 2630 rotate relative to each other. One end of the second elastic part 2720 may be fixedly coupled to the first control bar 2620, and the opposite end of the second elastic part 2720 may be fixedly coupled to the second control bar 2630.

The second elastic part 2720 may be configured to apply rotational force to the first control bar 2620 and the second control bar 2630 in a direction in which the angle between the first control bar 2620 and the second control bar 2630 increases.

Due to this structure, when the driver, for example, manually operates the vehicle display device such that the externally exposed area of the flexible display 2400 increases, the force required for the first roller 2310 to smoothly ascend in the first direction may be provided to the vehicle display device.

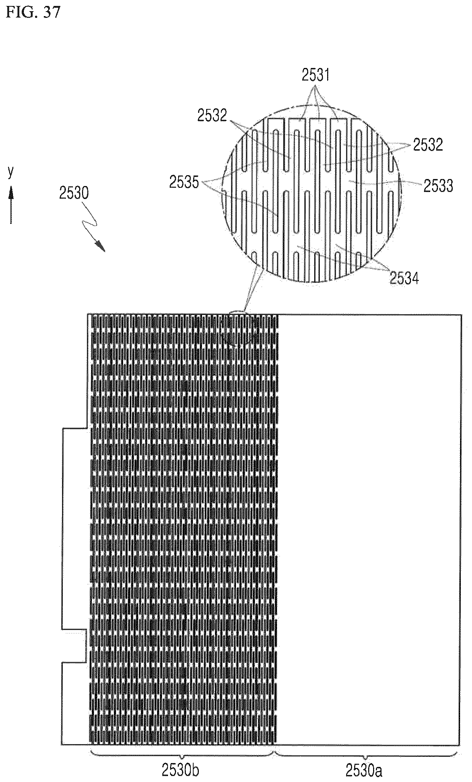

FIG. 37 is a view showing the backplate 2530 according to an embodiment. The backplate 2530 may be formed of a metal plate having elasticity. For example, the backplate 2530 may include a superelastic metal.

The backplate 2530 may allow the flexible display 2400 to be smoothly elastically deformed and elastically restored.

The backplate 2530 may be formed as a relatively thin plate. For example, the backplate 2530 may be formed to have an arbitrary thickness within a range of 0.05 to 0.2 mm, and may be formed to have a thickness of 0.1 mm.

The backplate 2530 may be implemented as a unitary metal plate overall, and may be divided into two or more areas. Specifically, the backplate 2530 may be configured to include a fixed area 2530a and a transformable area 2530b.

The fixed area 2530a is an area that overlaps the portion of the flexible display 2400 that is not bent. In the fixed area 2530a, the backplate 2530 may be formed as a flat metal plate as a whole.

The backplate 2530 may have a through-hole 2535 formed through a portion thereof corresponding to the roller, that is, through the transformable area 2530b. The transformable area 2530b is an area that overlaps the portion of the flexible display 2400 that is bent. The through-hole 2535 may be provided in a plural number, and may be formed through the transformable area 2530b so as to extend in the width direction (the leftward-rightward direction). That is, a plurality of through-holes may be formed through the transformable area 2530b of the backplate 2530 in the thickness direction of the backplate 2530.

In the transformable area 2530b, the backplate 2530 may be formed to be symmetrical in the leftward-rightward direction. The transformable area 2530b in which the plurality of through-holes 2535 are formed may include edges 2531, horizontal connectors 2532, and first vertical connectors 2533.

The edges 2531 are divided into a plurality of edges to form a left edge and a right edge of the backplate 2530. The edges 2531 have a predetermined length in the longitudinal direction, and are spaced apart from each other.

The horizontal connectors 2532 extend from the edges 2531 in the width direction. Two horizontal connectors 2532 extend from one edge 2531.

One first vertical connector connects two horizontal connectors 2532 extending from different edges 2531. That is, one first vertical connector 2533 connects two horizontal connectors 2532 which extend from two adjacent edges 2531 and are adjacent to each other. The first vertical connectors 2533 may be repeatedly formed along the width direction (the leftward-rightward direction), and the first vertical connectors 2533 may be spaced apart from each other at regular intervals.

Second vertical connectors 2534 may be formed in the transformable area 2530b, and one second vertical connector 2534 connects two horizontal connectors 2532 extending from the same edge 2531. The second vertical connectors 2534 may be repeatedly formed along the width direction (the leftward-rightward direction), and the second vertical connectors 2534 may be spaced apart from each other at regular intervals.

As described above, since the through-holes 2535, which are long in the width direction, are repeatedly formed in the transformable area 2530b, the transformable area 2530b may be easily bent with respect to the rotation axis of the width direction.

When a tensile force, which is an external force, is applied to the transformable area 2530b along the longitudinal direction, the edges 2531 and the first vertical connectors 2533 may be deformed to be spaced apart from each other in the longitudinal direction with respect to the horizontal connectors 2532, and the length of the transformable area 2530b may be increased over the entire area of the transformable area 2530b. When the external force is removed, the transformable area 2530b is elastically recovered to its original state.

Further, when a tensile force, which is an external force, is applied to the transformable area 2530b along the longitudinal direction, the first vertical connectors 2533 and the second vertical connectors 2534 may be deformed to be spaced apart from each other in the longitudinal direction with respect to the horizontal connector 2532, and the length of the transformable area 2530b may be increased over the entire area of the transformable area 2530b. When the external force is removed, the transformable area 2530b is elastically recovered to its original state.

Since the backplate 2530 includes the transformable area 2530b, the region of the flexible display 2400 that is bent may be more flexibly deformed. Therefore, upon the flexible display 2400 being bent in a region adjacent to the second roller 2320, elastic deformation of the flexible display 2400 is facilitated, and control of springback thereof is also facilitated.

Further, since the backplate 2530 includes the transformable area 2530b, the flexible display 2400 may be elastically deformed within a predetermined range along the longitudinal direction.

In the embodiment, since the externally exposed area of the flexible display 2400 is manually adjusted by the user or automatically adjusted by the actuator 2650, it is possible to adjust the size of the screen on which image information is displayed according to the convenience of the user.

As described above in association with embodiments, although some cases were described, other various embodiments are possible. The technical content of the embodiments described above may be combined in various ways unless they are not compatible, allowing new embodiments to be correspondingly implemented.

## Claims

1. A display device for a vehicle, comprising:
a first frame secured to a dashboard of a vehicle;
a second frame configured to be movable in a first direction with respect to the first frame;
a flexible display configured such that an externally exposed area of the flexible display changes according to a movement of the second frame in the first direction; and
an input interface configured to receive input for controlling operation of the flexible display,
wherein the externally exposed area of the flexible display changes based on characteristics of each of at least one user or each of at least one device provided in the vehicle.

2. The display device of claim 1, wherein the input interface is implemented as a hard key input interface disposed at a predetermined portion in the vehicle.

3. The display device of claim 1, wherein the input interface is implemented as a soft key input interface displayed on the flexible display.

4. The display device of one of claims 1 to 3, wherein the flexible display is configured such that the externally exposed area of the flexible display changes based on a control value inputted by a user through the input interface.

5. The display device of one of claims 1 to 4, wherein the flexible display reproduces a screen for control of the at least one device provided in the vehicle, and the externally exposed area of the flexible display changes according to characteristics of each of the at least one device.

6. The display device of claim 5, wherein the flexible display reproduces at least one of a navigation screen, a screen for operation of an air-conditioner, a screen for control of a driving device, a screen for video playback, or a screen for manipulation of an audio device,
wherein the externally exposed area of the flexible display is further configured to be largest when the navigation screen is reproduced.

7. The display device of one of claims 1 to 6, further comprising a camera disposed so as to be oriented toward a user in a driver seat,
wherein a controller provided in the vehicle identifies a user in the driver seat by recognizing a face of the user using the camera, and controls a size of the externally exposed area of the flexible display based on a preset value corresponding to the identified user.

8. The display device of claim 7, wherein, upon receiving a control signal inputted through the input interface, the controller controls the size of the externally exposed area of the flexible display based on the control signal inputted through the input interface, rather than based on a preset value corresponding to a user identified through the camera.

9. The display device of one of claims 1 to 8, further comprising:
a roller rotatably coupled to the second frame, the roller being configured to move in the first direction according to a movement of the second frame,
wherein the flexible display is partially wound around the roller and is bent by the roller,
one end portion of the flexible display is secured to the first frame, and
an externally exposed area of the front surface of the flexible display increases in response to an increasing of a distance between the first frame and the roller.

10. The display device of claim 9, further comprising:
a moving part configured to move the roller in the first direction; and
an actuator configured to provide a driving force to the moving part.

11. The display device of claim 10, wherein the moving part comprises:
a moving plate to which the second frame is coupled, the moving plate being configured to move in the first direction according to a movement of the roller in the first direction; and
a chain of which one side is coupled to the first frame, the chain being configured to be bent by the roller and to support at least a portion of a rear surface of the flexible display.

12. The display device of claim 11, wherein the moving part further comprises a backplate disposed so as to face the flexible display,
wherein at least a portion of the backplate is formed as an elastic metal plate, and
wherein the backplate comprises a through-hole formed in a portion of the backplate corresponding to the roller.

13. The display device of one of claims 1 to 8, further comprising:
a first roller disposed so as to be spaced apart from the first frame; and
a second roller rotatably coupled to the second frame, the second roller being configured to move in the first direction according to a movement of the second frame,
wherein the flexible display is partially wound around the second roller and is bent by the second roller, and
wherein an externally exposed area of the front surface of the flexible display increases in response to an increasing of a distance between the first roller and the second roller.

14. The display device of claim 13, further comprising:
a moving part configured to move the second roller in the first direction; and
a guide part configured to guide a movement of the moving part.

15. The display device of claim 14, wherein the moving part comprises:
a moving plate coupled at one end portion to the second frame, the moving plate being configured to move in the first direction according to a movement of the second roller in the first direction; and
a chain of which one end portion is coupled to the moving plate, the chain being configured to be bent by the first roller and to support at least a portion of a rear surface of the flexible display.

## Amended claims

### Amended claims in accordance with Rule 137(2) EPC.

1. A display device for a vehicle, comprising:
a first frame (1100) secured to a dashboard (10) of a vehicle;
a second frame (1200) configured to be movable in a first direction with respect to the first frame (1100);
a flexible display (500, 1400) configured such that an externally exposed area of the flexible display (500, 1400) changes according to a movement of the second frame (1200) in the first direction; and
an input interface (600) configured to receive input for controlling operation of the flexible display (500, 1400),
wherein the externally exposed area of the flexible display (500, 1400) changes based on characteristics of each of at least one user or each of at least one device provided in the vehicle,
wherein the flexible display (500, 1400) is configured such that the externally exposed area of the flexible display (500, 1400) changes based on a control value inputted by a user through the input interface (600), or
wherein the flexible display (500, 1400) reproduces a screen for control of the at least one device provided in the vehicle, and the externally exposed area of the flexible display (500, 1400) changes according to characteristics of each of the at least one device.

2. The display device of claim 1, wherein the input interface (600) is implemented as a hard key input interface disposed at a predetermined portion in the vehicle.

3. The display device of claim 1, wherein the input interface (600) is implemented as a soft key input interface displayed on the flexible display.

4. The display device of claim 1, wherein the flexible display (500, 1400) reproduces at least one of a navigation screen, a screen for operation of an air-conditioner, a screen for control of a driving device, a screen for video playback, or a screen for manipulation of an audio device,
wherein the externally exposed area of the flexible display (500, 1400) is further configured to be largest when the navigation screen is reproduced.

5. The display device of one of claims 1 to 4, further comprising a camera (800) disposed so as to be oriented toward a user in a driver seat,
wherein a controller (400) provided in the vehicle is configured to identify a user in the driver seat by recognizing a face of the user using the camera, and to control a size of the externally exposed area of the flexible display (500, 1400) based on a preset value corresponding to the identified user.

6. The display device of claim 5, wherein, upon receiving a control signal inputted through the input interface (600), the controller (400) is configured to control the size of the externally exposed area of the flexible display (500, 1400) based on the control signal inputted through the input interface (600), rather than based on a preset value corresponding to a user identified through the camera (800).

7. The display device of one of claims 1 to 6, further comprising:
a roller (1300) rotatably coupled to the second frame (1200), the roller (1300) being configured to move in the first direction according to a movement of the second frame (1200),
wherein the flexible display (500, 1400) is partially wound around the roller (1300) and is bent by the roller (1300),
one end portion of the flexible display (500, 1400) is secured to the first frame (1100), and
an externally exposed area of the front surface of the flexible display (500, 1400) increases in response to an increasing of a distance between the first frame (1100) and the roller (1300).

8. The display device of claim 7, further comprising:
a moving part (2500) configured to move the roller (1300) in the first direction; and
an actuator (2650) configured to provide a driving force to the moving part (2500) .

9. The display device of claim 8, wherein the moving part (2500) comprises:
a moving plate (2510) to which the second frame (1200) is coupled, the moving plate (2510) being configured to move in the first direction according to a movement of the roller (1300) in the first direction; and
a chain (2520) of which one side is coupled to the first frame (1100), the chain (2520) being configured to be bent by the roller (1300) and to support at least a portion of a rear surface of the flexible display (500, 1400).

10. The display device of claim 9, wherein the moving part (2500) further comprises a backplate (2530) disposed so as to face the flexible display (500, 1400),
wherein at least a portion of the backplate (2530) is formed as an elastic metal plate, and
wherein the backplate (2530) comprises a through-hole (2535) formed in a portion of the backplate (2530) corresponding to the roller. (1300)

11. The display device of one of claims 1 to 6, further comprising:
a first roller (2310) disposed so as to be spaced apart from the first frame (1100); and
a second roller (2320) rotatably coupled to the second frame (1200), the second roller (2320) being configured to move in the first direction according to a movement of the second frame (1200),
wherein the flexible display (500, 1400) is partially wound around the second roller (2320) and is bent by the second roller (2320), and
wherein an externally exposed area of the front surface of the flexible display (500, 1400) increases in response to an increasing of a distance between the first roller (2310) and the second roller (2320).

12. The display device of claim 11, further comprising:
a moving part (2500) configured to move the second roller (2320) in the first direction; and
a guide part (2600) configured to guide a movement of the moving part (2500).

13. The display device of claim 12, wherein the moving part (2500) comprises:
a moving plate (2510) coupled at one end portion to the second frame (1200), the moving plate (2510) being configured to move in the first direction according to a movement of the second roller (2320) in the first direction; and
a chain (2520) of which one end portion is coupled to the moving plate (2510), the chain (2520) being configured to be bent by the first roller (2310) and to support at least a portion of a rear surface of the flexible display (500, 1400).
